# EUROPEAN PATENT APPLICATION

(11) **EP 4 210 456 A1**
(43) Date of publication of application: **12.07.2023**
(21) Application number: 22208306.5
(22) Date of filing: 18.11.2022
(51) Int. Cl.: H10K 59/122, H10K 59/121

(54) **DISPLAY DEVICE AND DISPLAY PANEL**

(30) Priority: 31.12.2021 KR 20210194138
(71) Applicant: LG Display Co., Ltd., SEOUL, 07336 (KR)
(72) Inventor: KIM, SeokHyun, 10845 Paju-si (KR); KIM, KwanSoo, 10845 Paju-si (KR); KIM, MinJee, 10845 Paju-si (KR); GO, Youngjune, 10845 Paju-si (KR); SONG, Mingeun, 10845 Paju-si (KR); JUNG, Sangwon, 10845 Paju-si (KR)
(74) Representative: Viering, Jentschura & Partner mbB Patent- und Rechtsanwälte

(57) **Abstract**

Embodiments of the present disclosure relate to a display device (100) and a display panel (110), and more particularly, the present disclosure provide a display device (100) comprising: a display panel (110) including a light emitting area (EA) and a transmissive area (TA1, TA2) for conveying light to a sensor disposed beneath the display panel (110). The transmissive area (TA1, TA2) may comprise a transmissive layer for conveying light and having a non-planar top surface and a cathode patterning material (CPM) formed to cover the non-planar top surface of the transmissive layer.

## Description

### CROSS-REFERENCE TO RELATED APPLICATION

This application claims the priority benefit of Republic of Korea Patent Application No. 10-2021-0194138, filed on December 31, 2021, in the Korean Intellectual Property Office.

### BACKGROUND

### Field of the Disclosure

The present disclosure is related to a display device and a display panel in which product defects are diminished and reliability is improved.

### Description of the Background

A display device may provide a photographing function and various detection functions in addition to an image display function. To this end, the display device can include an optical electronic device (also referred to as a light receiving device or a sensor) such as a camera and a detection sensor.

Since the optical electronic device is configured to receive light from the front side of the display device, the optical electronic device should be disposed where light reception is advantageous. Therefore, in the related art, the camera (camera lens) and the detection sensor was installed and exposed on the front of the display device. For this reason, the bezel of the display panel is widened or a notch or a physical hole is formed in the display area of the display panel, and a camera or a detection sensor is disposed in the notch or physical hole.

### SUMMARY

An optical electronic device, such as a camera and a detection sensor, performs a predetermined function by receiving light from the front are provided in the display device. In some aspects, a size of the bezel may increase in the front of the display device or there may be restrictions on the front design of the display device.

Accordingly, in the field of display technology, a technology for providing an optical electronic device such as a camera and a detection sensor without reducing the area of the display area of the display panel is being studied.

For example, a technology has been proposed in which an optical electronic device, such as a camera and a detection sensor, is disposed under the display area of a display panel, but subpixels are disposed in only some light emitting area of optical areas overlapping with the optical electronic device and subpixels are not disposed in remaining transmissive area.

However, a cathode patterning material formed over a bank in the transmissive area within the optical area is easily delaminated from the upper capping layer, thereby it may cause a defect in the display device.

Accordingly, the instant disclosure provides a display device and a display panel capable of reducing the coupling failure between the cathode patterning material and the capping layer formed over the transmissive area within the optical area.

Aspects of the present disclosure may provide a display device and a display panel capable of strengthening a bond between the cathode patterning material and the capping layer, and capable of reducing defects by forming an engraved pattern with a certain shape over the bank formed in the transmissive area within the optical area. Aspects of the present disclosure may provide a display device according to claim 1. Further aspects are described in the dependent claims.

The display device according to the aspects of the present disclosure may comprise a display panel in which an optical area divided into a transmissive area and a light emitting area, and a normal area including a plurality of light emitting areas outside the optical area are formed in a display area; a gate driving circuit configured to supply a gate signal to the display panel; a data driving circuit configured to convert image data into data voltage and supply it to the display panel; and a display controller configured to control the gate driving circuit and the data driving circuit; wherein the transmissive area includes a bank dividing the light emitting area and including a bank pattern formed on an upper surface; a cathode patterning material formed to cover at least a portion of the bank; and a capping layer formed on the cathode patterning material.

The display panel according to the aspects of the present disclosure may comprise an optical area divided into a transmissive area and a light emitting area; and a normal area including a plurality of light emitting areas outside the optical area in a display area; wherein the transmissive area may include a bank dividing the light emitting area and including a bank pattern formed on an upper surface; a cathode patterning material formed to cover at least a portion of the bank; and a capping layer formed on the cathode patterning material.

A display panel according to the aspects of the present disclosure may comprise a light emitting area and a transmissive area for conveying light to a sensor disposed beneath the display panel. The transmissive area may comprise a transmissive layer for conveying light and having a non-planar top surface and a cathode patterning material formed to cover the non-planar top surface of the transmissive layer.

According to aspects of the present disclosure, it may provide a display device and a display panel capable of reducing the coupling failure between the cathode patterning material and the capping layer formed over the transmissive area within the optical area.

According to aspects of the present disclosure, it may provide a display device and a display panel capable of strengthening a bond between the cathode patterning material and the capping layer, and capable of reducing defects by forming an engraved pattern with a certain shape over the bank formed in the transmissive area within the optical area.

### BRIEF DESCRIPTION OF THE DRAWINGS

The accompanying drawings, which are included to provide a further understanding of the disclosure and are incorporated in and constitute a part of the disclosure, illustrate aspects of the disclosure and together with the description serve to explain the principle of the disclosure. In the drawings:
FIGS. 1A, 1B and 1C are plan views illustrating a display device 100 according to aspects of the present disclosure;
FIG. 2 illustrates a system configuration of the display device 100 according to aspects of the present disclosure;
FIG. 3 illustrates an equivalent circuit of a subpixel SP in the display panel 110 according to aspects of the present disclosure;
FIG. 4 illustrates arrangements of subpixels SP in the three areas NA, OA1, OA2 included in the display area DA of the display panel 110 according to aspects of the present disclosure;
FIG. 5A illustrates arrangements of signal lines in each of the first optical area OA1 and the normal area NA of the display panel 110 according to aspects of the present disclosure,;
FIG. 5B illustrates arrangements of signal lines in each of the second optical area OA2 and the normal area NA of the display panel 110 according to aspects of the present disclosure;
FIG. 6 is cross-sectional view of an optical area OA of the display panel 110 according to aspects of the present disclosure;
FIGS. 7A and 7B illustrate enlarged views of an area corresponding to the light emitting element ED in the optical area OA of the display panel 110 according to aspects of the present disclosure;
FIGS. 8 to 10 illustrate plan views of structures of a bank pattern and a cathode patterning material formed in a transmissive area of an optical area in a display device according to aspects of the present disclosure; and
FIGs. 11A and 11B illustrate a cross-sectional photographs comparing a case in which a bank pattern is not formed and a case in which a bank pattern is formed in a transmissive area of an optical area in a display device according to aspects of the present disclosure.

### DETAILED DESCRIPTION

In the following description of examples or aspects of the present disclosure, reference will be made to the accompanying drawings in which it is shown by way of illustration specific examples or aspects that can be implemented, and in which the same reference numerals and signs can be used to designate the same or like components even when they are shown in different accompanying drawings from one another. Further, in the following description of examples or aspects of the present disclosure, detailed descriptions of well-known functions and components incorporated herein will be omitted when it is determined that the description may make the subject matter in some aspects of the present disclosure rather unclear. The terms such as "including", "having", "containing", "constituting" "make up of', and "formed of' used herein are generally intended to allow other components to be added unless the terms are used with the term "only". As used herein, singular forms are intended to include plural forms unless the context clearly indicates otherwise.

Terms, such as "first", "second", "A", "B", "(A)", or "(B)" may be used herein to describe elements of the present disclosure. Each of these terms is not used to define essence, order, sequence, or number of elements etc., but is used merely to distinguish the corresponding element from other elements.

When it is mentioned that a first element "is connected or coupled to", "contacts or overlaps" etc. a second element, it should be interpreted that, not only can the first element "be directly connected or coupled to" or "directly contact or overlap" the second element, but a third element can also be "interposed" between the first and second elements, or the first and second elements can "be connected or coupled to", "contact or overlap", etc. each other via a fourth element. Here, the second element may be included in at least one of two or more elements that "are connected or coupled to", "contact or overlap", etc. each other.

When time relative terms, such as "after," "subsequent to," "next," "before," and the like, are used to describe processes or operations of elements or configurations, or flows or steps in operating, processing, manufacturing methods, these terms may be used to describe nonconsecutive or non-sequential processes or operations unless the term "directly" or "immediately" is used together.

In addition, when any dimensions, relative sizes etc. are mentioned, it should be considered that numerical values for an elements or features, or corresponding information (e.g., level, range, etc.) include a tolerance or error range that may be caused by various factors (e.g., process factors, internal or external impact, noise, etc.) even when a relevant description is not specified. Further, the term "may" fully encompasses all the meanings of the term "can".

Hereinafter, various embodiments of the present disclosure will be described in detail with reference to the accompanying drawings.

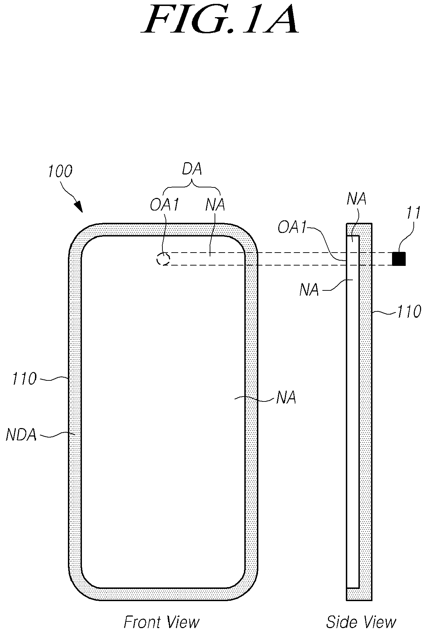

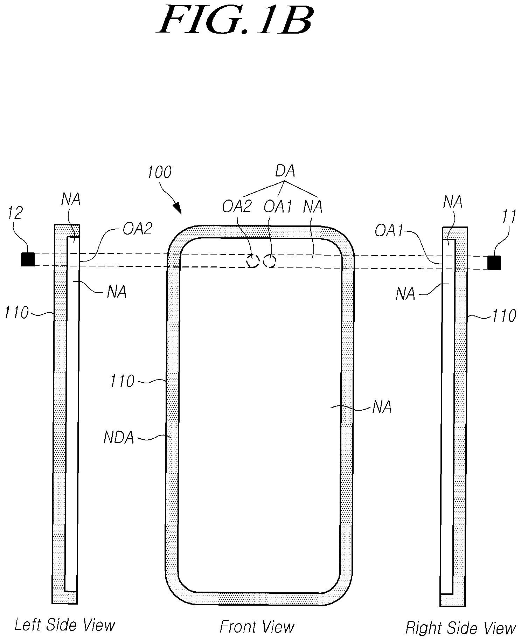

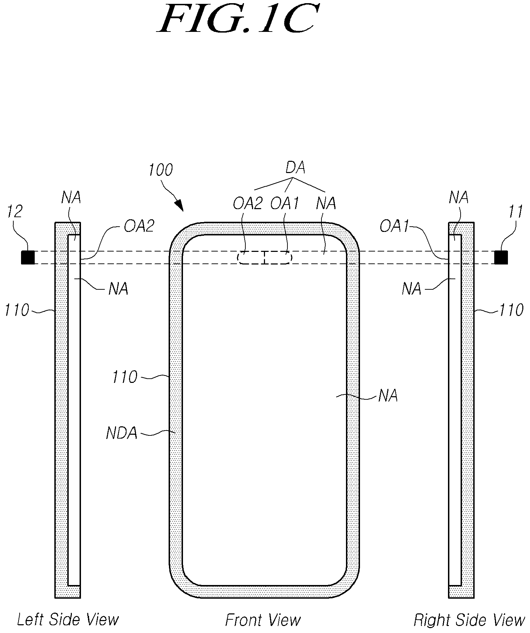

FIGS. 1A, 1B and 1C are plan views illustrating a display device 100 according to aspects of the present disclosure.

Referring to FIGS. 1A, 1B, and 1C, the display device 100 according to aspects of the present disclosure can include a display panel 110 for displaying images, and one or more optical electronic devices 11, 12.

The display panel 110 can include a display area DA in which an image is displayed and a non-display area NDA in which an image is not displayed.

A plurality of subpixels can be disposed in the display area DA, and several types of signal lines for driving the plurality of subpixels can be disposed therein.

The non-display area NDA may refer to an area outside of the display area DA. Several types of signal lines can be disposed in the non-display area NDA, and several types of driving circuits can be connected thereto. The non-display area NDA may be bent to be invisible from the front of the display panel or may be covered by a case (not shown). The non-display area NDA may be also referred to as a bezel or a bezel area.

Referring to FIGS. 1A, 1B, and 1C, in the display device 100 according to aspects of the present disclosure, one or more optical electronic devices 11, 12 may be located under, or at a lower portion of, the display panel 110 (the opposite side to the viewing surface thereof).

Light can enter the front surface (viewing surface) of the display panel 110, pass through the display panel 110, reach one or more optical electronic devices 11, 12 located under, or at the lower portion of, the display panel 110 (the opposite side to the viewing surface).

The one or more optical electronic devices 11, 12 can receive or detect light transmitting through the display panel 110 and perform a predefined function based on the received light. For example, the one or more optical electronic devices 11, 12 can include one or more of an image capture device such as a camera (an image sensor), and/or the like, and a sensor such as a proximity sensor, an illuminance sensor, and/or the like.

Referring to FIGS. 1A, 1B, and 1C, in the display panel 110 according to aspects of the present disclosure, the display area DA may include one or more optical areas OA1, OA2 and a normal area NA.

Referring to FIGS. 1A, 1B, and 1C, the one or more optical areas OA1, OA2 may be one or more areas overlapping the one or more optical electronic devices 11, 12.

According to an example of FIG. 1A, the display area DA may include a first optical area OA1 and a normal area NA. In this example, at least a part of the first optical area OA1 may overlap a first optical electronic device 11.

Referring to FIG. 1B, in one aspect, the display area DA may include a first optical area OA1, a second optical area OA2, and a normal area NA. In the example of FIG. 1B, the normal area NA may be located between the first optical area OA1 and the second optical area OA2. In this case, at least a part of the first optical area OA1 may overlap the first optical electronic device 11, and at least a part of the second optical area OA2 may overlap a second optical electronic device 12.

According to an example of FIG. 1C, the display area DA may include a first optical area OA1, a second optical area OA2, and a normal area NA. In the example of FIG. 1C, the normal area NA may not be located between the first optical area OA1 and the second optical area OA2. That is, the first optical area OA1 and the second optical area OA2 may contact each other. In this case, at least a part of the first optical area OA1 may overlap the first optical electronic device 11, and at least a part of the second optical area OA2 may overlap the second optical electronic device 12.

Both an image display structure and a light transmission structure may be implemented in the one or more optical areas OA1, OA2. That is, since the one or more optical areas OA1, OA2 are a part of the display area DA, subpixels for displaying images may be disposed in the one or more optical areas OA1, OA2. Further, for enabling light to be transmitted to the one or more optical electronic devices 11, 12, a light transmission structure may be implemented in the one or more optical areas OA1, OA2.

According to the aspects described above, the one or more optical electronic devices 11, 12 may be located on the back of the display panel 110 (e.g., under or on a lower portion of the display panel 110), even though the one or more optical electronic devices 11, 12 are configured to receive or detect light.

That is, the one or more optical electronic devices 11, 12 are not exposed on the front surface (viewing surface) of the display panel 110. Accordingly, when a user looks at the front of the display device 110, the optical electronic devices 11, 12 are not visible to the user.

In one illustrative example, the first optical electronic device 11 may be an image sensor, and the second optical electronic device 12 may be a sensor such as a proximity sensor, an illuminance sensor, and/or the like. For example, the sensor may be an infrared sensor capable of detecting infrared light.

In another embodiment, the first optical electronic device 11 may be a proximity sensor, and the second optical electronic device 12 may be the camera.

Hereinafter, for convenience of description, the first optical electronic device 11 will be presumed to be an camera for obtaining images, and the second optical electronic device 12 will be presumed to be a proximity sensor, an illuminance sensor, an infrared sensor, and the like. Here, the camera may include various components for capturing images such a camera lens, an image sensor, or a unit including at least one of the camera lens and the image sensor.

In a case where the first optical electronic device 11 is the camera, the camera may be located on the back side of (under or on a lower portion of) the display panel 110, and may be a front facing camera capable of capturing objects in a front direction of the display panel 110. Accordingly, the user can capture an image through the camera that is not visible on the viewing surface while looking at the viewing surface of the display panel 110.

Although the normal area NA and the one or more optical areas OA1, OA2 included in the display area DA in each of FIGS. 1A to 1C are areas for images to be displayed, the normal area NA is an area where a light transmission structure may not be implemented, however, the one or more optical areas OA1, OA2 are areas in which the light transmission structure should be implemented.

Accordingly, the one or more optical areas OA1, OA2 may have a transmittance greater than or equal to a predetermined level, i.e., a relatively high transmittance, and the normal area NA may not have light transmittance or have a transmittance less than the predetermined level i.e., a relatively low transmittance.

For example, the one or more optical areas OA1, OA2 may have a resolution, a subpixel arrangement structure, the number of subpixels per unit area, an electrode structure, a line structure, an electrode arrangement structure, a line arrangement structure, or/and the like different from that/those of the normal area NA.

In some aspects, the number of subpixels per unit area in the one or more optical areas OA1, OA2 may be smaller than the number of subpixels per unit area in the normal area NA. That is, the resolution of the one or more optical areas OA1, OA2 may be lower than that of the normal area NA. The number of subpixels per unit area may correspond to a resolution, a pixel density, or a degree of integration of pixels. For example, the unit of the number of subpixels per unit area may be pixels per inch (PPI), which represents the number of pixels within 1 inch.

For example, the number of subpixels per unit area in the first optical areas OA1 may be smaller than the number of subpixels per unit area in the normal area NA. The number of subpixels per unit area in the second optical areas OA2 may be greater than or equal to the number of subpixels per unit area in the first optical areas OA1, and be smaller than the number of subpixels per unit area.

The first optical area OA1 may have various shapes, such as a circle, an ellipse, a quadrangle, a hexagon, an octagon, or the like. The second optical area OA2 may have various shapes, such as a circle, an ellipse, a quadrangle, a hexagon, an octagon, or the like. The first optical area OA1 and the second optical area OA2 may have the same shape or different shapes.

Referring to FIG. 1C, the first optical area OA1 and the second optical area OA2 may contact each other, and the entire optical area including the first optical area OA1 and the second optical area OA2 may also have various shapes, such as a circle, an ellipse, a quadrangle, a hexagon, an octagon or the like.

Hereinafter, for convenience of description, discussions will be conducted based on an embodiment in which each of the first optical area OA1 and the second optical area OA2 has a circular shape.

When the display device 100 according to aspects of the present disclosure has a structure in which the first optical electronic device 11 (e.g., a camera, a light sensor, etc.) is located under or is a lower portion of the display panel 100 without being exposed to the outside, the display device 100 according to aspects of the present disclosure may be referred to as a display to which under-display camera (UDC) technology is applied.

According to this configuration, in the case of the display device 100 according to aspects of the present disclosure, a notch or a camera hole is not required to be formed in the display panel 100 to expose a camera, the display area DA is maintained.

In other words, since the notch or the camera hole for camera exposure are not formed in the display panel 110, the size of the bezel area can be reduced, and a substantial disadvantage in design can be removed or reduced, thereby increasing the degree of freedom in design.

Although the one or more optical electronic devices 11, 12 are located on the below an exposed surface of the display panel 110 (e.g. under or on lower portion of the display panel 110) in the display device 100 according to aspects of the present disclosure, the one or more optical electronic devices 11, 12 may be configured to receive or detect light.

Further, in the display device 100 according to aspects of the present disclosure, although one or more optical electronic devices 11, 12 are located on the back of (under or a lower portion of) the display panel 110 to be hidden and located to be overlapped with the display area DA, it is necessary for image display to be normally performed in the one or more optical areas OA1, OA2 overlapping the one or more optical electronic devices 11, 12 in the area DA.

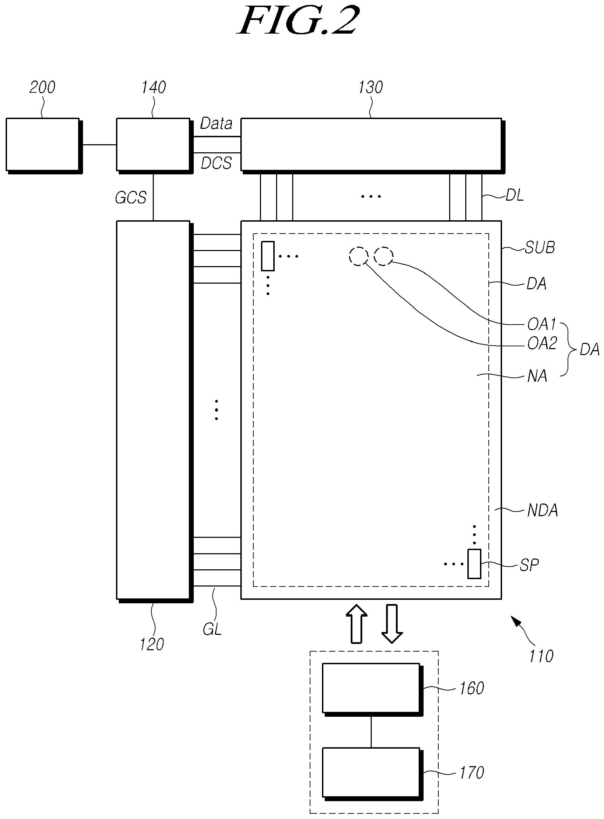

FIG. 2 illustrates a system configuration of the display device 100 according to aspects of the present disclosure.

Referring to FIG. 2, the display device 100 may include the display panel 110 and a display driving circuit for displaying an image.

The display driving circuit is configured to drive the display panel 110 and may include a data driving circuit 130, a gate driving circuit 120, a display controller 140, and the like.

The display panel 110 can include the display area DA in which an image is displayed and the non-display area NDA in which an image is not displayed. The non-display area NDA may be an area outside of the display area DA, and may also be referred to as a bezel area. All or a part of the non-display area NDA may be an area visible from the front surface of the display device 100, or an area that is bent and not visible from the front surface of the display device 100.

The display panel 110 may include a substrate SUB and a plurality of subpixels SP disposed on the substrate SUB. The display panel 110 may further include various types of signal lines to drive the plurality of subpixels SP.

The display device 100 according to aspects of the present disclosure may be a liquid crystal display device, or the like, or a self-emissive display device in which light is emitted from the display panel 110 itself. When the display device 100 according to aspects of the present disclosure is the self-emissive display device, each of the plurality of subpixels SP may include a light emitting element.

In one aspect, the display device 100 may be an organic light emitting display device in which the light emitting element is implemented using an organic light emitting diode (OLED). In other aspects, the display device 100 may be an inorganic light emitting display device in which the light emitting element is implemented using an inorganic material-based light emitting diode. In yet another aspect, the display device 100 may be a quantum dot display device in which the light emitting element is implemented using quantum dots, which are self-emissive semiconductor crystals.

The structure of each of the plurality of subpixels SP may vary according to the type of the display devices 100. For example, when the display device 100 is a self-emissive display device including self-emissive subpixels SP, each subpixel SP may include a self-emissive light emitting element, one or more transistors, and one or more capacitors.

For example, various types of signal lines may include a plurality of data lines DL for carrying data signals (also referred to as data voltages or image signals), a plurality of gate lines GL for carrying gate signals (also referred to as scan signals), and the like.

The plurality of data lines DL and the plurality of gate lines GL may intersect each other. Each of the plurality of data lines DL may be disposed to extend in a first direction. Each of the plurality of gate lines GL may be disposed to extend in a second direction.

Here, the first direction may be a column direction, and the second direction may be a row direction. Alternatively, the first direction may be the row direction, and the second direction may be the column direction.

The data driving circuit 130 is a circuit for driving the plurality of data lines DL, and can supply data signals to the plurality of data lines DL. The gate driving circuit 120 is a circuit for driving the plurality of gate lines GL, and can supply gate signals to the plurality of gate lines GL.

The display controller 140 is configured to control the data driving circuit 130 and the gate driving circuit 120, and may control driving timing for the plurality of data lines DL and driving timing for the plurality of gate lines GL.

The display controller 140 can supply a data driving control signal DCS to the data driving circuit 130 to control the data driving circuit 130 and supply a gate driving control signal GCS to the gate driving circuit 120 to control the gate driving circuit 120.

The display controller 140 can receive input image data from a host system 200 and supply image data Data to the data driving circuit 130 based on the input image data.

The data driving circuit 130 may supply data signals to a plurality of data lines DL according to driving timing control of the display controller 140.

The data driving circuit 130 can receive the digital image data Data from the display controller 140, convert the received image data Data into analog data signals, and supply the resulting analog data signals to the plurality of data lines DL.

The gate driving circuit 120 may supply gate signals to a plurality of gate lines GL according to timing control of the display controller 140. The gate driving circuit 120 can receive a first gate voltage corresponding to a turn-on level voltage and a second gate voltage corresponding to a turn-off level voltage along with various gate driving control signals GCS, generate gate signals, and supply the generated gate signals to the plurality of gate lines GL.

In some aspects, the data driving circuit 130 may be connected to the display panel 110 in a tape automated bonding (TAB) type, or connected to a conductive pad such as a bonding pad of the display panel 110 in a chip on glass (COG) type or a chip on panel (COP) type, or connected to the display panel 110 in a chip on film (COF) type.

The gate driving circuit 120 may be connected to the display panel 110 in the TAB type, or connected to a conductive pad such as a bonding pad of the display panel 110 in the COG type or the COP type, or connected to the display panel 110 in the COF type.

The gate driving circuit 120 may be disposed in the non-display area NDA of the display panel 110 in a gate in panel (GIP) type. The gate driving circuit 120 may be disposed on or over the substrate, or connected to the substrate. That is, in the case of the GIP type, the gate driving circuit 120 may be disposed in the non-display area NDA of the substrate. The gate driving circuit 120 may be connected to the substrate in the case of the COG type, the COF type, or the like.

At least one of the data driving circuit 130 and the gate driving circuit 120 may be disposed in the display area DA of the display panel 110. For example, at least one of the data driving circuit 130 and the gate driving circuit 120 may be disposed not to overlap subpixels SP or disposed to overlap one or more, or all, of the subpixels SP.

The data driving circuit 130 may also be located in, but not limited to, one portion (e.g., an upper portion or a lower portion) of the display panel 110. In some aspects, the data driving circuit 130 may be located in, but not limited to, two portions (e.g., an upper portion and a lower portion) of the display panel 110 or at least two of four portions (e.g., the upper portion, the lower portion, a left portion, and a right portion) of the display panel 110 according to driving schemes, panel design schemes, or the like.

The gate driving circuit 120 may also be located in, but not limited to, one portion (e.g., a left portion or a right portion) of the display panel 110. In some aspects, the gate driving circuit 120 may be located in, but not limited to, two portions (e.g., a left portion and a right portion) of the display panel 110 or at least two of four portions (e.g., an upper portion, a lower portion, the left portion, and the right portion) of the display panel 110 according to driving schemes, panel design schemes, or the like.

The display controller 140 may be implemented in a separate component from the data driving circuit 130, or integrated with the data driving circuit 130 and thus implemented in an integrated circuit.

The display controller 140 may include a timing controller used in the typical display technology or a controller or a control device capable of additionally performing other control functions in addition to the function of the typical timing controller. In some aspects, the display controller 140 may be a controller or a control device different from the timing controller, or circuitry or a component included in the controller or the control device. The display controller 140 may be implemented with various circuits or electronic components such as an integrated circuit (IC), a field programmable gate array (FPGA), an application specific integrated circuit (ASIC), a processor, and/or the like.

The display controller 140 may be mounted on a printed circuit board, a flexible printed circuit, and/or the like and be electrically connected to the gate driving circuit 130 and the data driving circuit 120 through the printed circuit board, flexible printed circuit, and/or the like.

The display controller 140 may transmit signals to, and receive signals from, the data driving circuit 130 via one or more predetermined interfaces. In some aspects, such interfaces may include a low voltage differential signaling (LVDS) interface, an embedded point-to-point interface (EPI), a serial peripheral interface (SPI), and the like.

In order to further provide a touch sensing function, as well as an image display function, the display device 100 according to aspects of the present disclosure may include at least one touch sensor, and a touch circuit capable of detecting whether a touch event occurs by a touch object such as a finger, a pen, or the like, or of detecting a corresponding touch position, by sensing the touch sensor.

The touch circuit may include a touch driving circuit 160 capable of generating and providing touch sensing data by driving and sensing the touch sensor, a touch controller 170 capable of detecting the occurrence of a touch event, or detecting a touch position using the touch sensing data, and the like.

The touch sensor may include a plurality of touch electrodes. The touch sensor may further include a plurality of touch lines for electrically connecting the plurality of touch electrodes to the touch driving circuit 160.

The touch sensor may be disposed in a touch panel, or in the form of a touch panel, outside of the display panel 110, or be disposed inside of the display panel 110. When the touch sensor is disposed in the touch panel, or in the form of the touch panel that is outside of (e.g., not integral to) the display panel 110, the touch sensor is referred to as an add-on type. When the add-on type of touch sensor is implemented into the display panel 110, the touch panel and the display panel 110 may be separately manufactured and are combined during an assembly process. The add-on type of touch panel may include a touch panel substrate and a plurality of touch electrodes on the touch panel substrate.

When the touch sensor is disposed inside of (e.g., integral to) the display panel 110, the touch sensor may be disposed over the substrate SUB together with signal lines and electrodes related to display driving during the process of manufacturing the display panel 110.

The touch driving circuit 160 can supply a touch driving signal to at least one of the plurality of touch electrodes, and sense at least one of the plurality of touch electrodes to generate touch sensing data.

The touch circuit can perform touch sensing using a self-capacitance sensing method or a mutual-capacitance sensing method.

When the touch circuit performs touch sensing in the self-capacitance sensing method, the touch sensing circuit can perform touch sensing based on capacitance between each touch electrode and a touch object (e.g., a finger, a pen, etc.).

According to the self-capacitance sensing method, each of the plurality of touch electrodes can serve as both a driving touch electrode and a sensing touch electrode. The touch driving circuit 160 can drive all or a part of the plurality of touch electrodes and sense all or a part of the plurality of touch electrodes.

When the touch circuit performs touch sensing in the mutual-capacitance sensing method, the touch circuit can perform touch sensing based on capacitance between touch electrodes.

According to the mutual-capacitance sensing method, the plurality of touch electrodes are divided into driving touch electrodes and sensing touch electrodes. The touch driving circuit 160 can drive the driving touch electrodes and sense the sensing touch electrodes.

The touch driving circuit 160 and the touch controller 170 included in the touch circuit may be implemented in separate devices or in a single device. Further, the touch driving circuit 160 and the data driving circuit 130 may be implemented in separate devices or in a single device.

The display device 100 may further include a power supply circuit for supplying various types of power to the display driving circuit and/or the touch circuit.

The display device 100 according to aspects of the present disclosure may be a mobile terminal such as a smart phone, a tablet, a wearable device such as a smart watch, or the like, or a monitor, a television (TV), or the like. Such devices may be of various types, sizes, and shapes. The display device 100 according to aspects of the present disclosure are not limited thereto, and includes displays of various types, sizes, and shapes for displaying information or images.

As described above, the display area DA of the display panel 110 may include a normal area NA and one or more optical areas OA1, OA2.

The normal area NA and the one or more optical areas OA1, OA2 are areas configured to display an image. However, the normal area NA is an area in which a light transmission structure may not be implemented, and the one or more optical areas OA1, OA2 are areas in which the light transmission structures may be implemented.

As discussed above with respect to the examples of FIGS. 1A to 1C, although the display area DA of the display panel 110 may include the one or more optical areas OA1, OA2 in addition to the normal area NA, for convenience of description, in the discussion that follows, it is assumed that the display area DA includes first and second optical areas OA1, OA2, and a normal area NA.

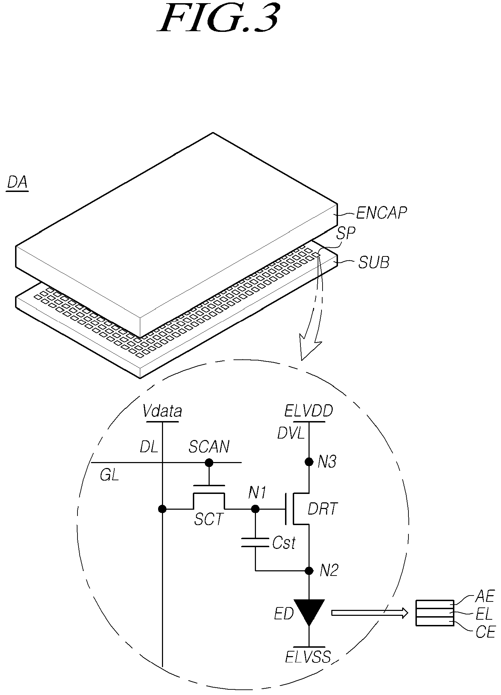

FIG. 3 illustrates an equivalent circuit of a subpixel SP in the display panel 110 according to aspects of the present disclosure.

Referring to FIG. 3, in the display panel 110 according to aspects of the present disclosure, each subpixels SP disposed in the normal area NA, the first optical area OA1, and the second optical area OA2 included in the display area DA may include a light emitting element ED, a driving transistor DRT for driving the light emitting element ED, a scan transistor SCT for transmitting a data voltage Vdata to a first node N1 of the driving transistor DRT, a storage capacitor Cst for maintaining a voltage at a substantially constant level during one frame, and the like.

The driving transistor DRT may include the first node N1 to which a data voltage Vdata is applied, a second node N2 electrically connected to the light emitting element ED, and a third node N3 to which a driving voltage ELVDD through a driving voltage line DVL is applied. In the driving transistor DRT, the first node N1 may be a gate node, the second node N2 may be a source node or a drain node, and the third node N3 may be the drain node or the source node.

The light emitting element ED may include an anode electrode AE, a light emitting layer EL, and a cathode electrode CE. The anode electrode AE may be a pixel electrode disposed in each subpixel SP and may be electrically connected to the second node N2 of the driving transistor DRT of each subpixel SP. The cathode electrode CE may be a common electrode commonly disposed in the plurality of subpixels SP, and a base voltage ELVSS such as a low-level voltage may be applied to the cathode electrode CE.

For example, the anode electrode AE may be the pixel electrode, and the cathode electrode CE may be the common electrode. In another example, the anode electrode AE may be the common electrode, and the cathode electrode CE may be the pixel electrode. For the convenience of description, in the discussion that follows, it is assumed that the anode electrode AE is the pixel electrode, and the cathode electrode CE is the common electrode unless explicitly stated otherwise.

The light emitting element ED may be, for example, an OLED, an inorganic light emitting diode, a quantum dot light emitting element, or the like. When the light emitting element ED comprises an OLED, the light emitting layer EL thereof may include an organic emissive layer that is implemented with an organic material.

The scan transistor SCT may be turned on and off by a scan signal SCAN that applied to the gate of the scan transistor SCT through a gate line GL, and be electrically connected between the first node N1 of the driving transistor DRT and a data line DL.

The storage capacitor Cst may be electrically connected between the first node N1 and the second node N2 of the driving transistor DRT.

Each subpixel SP may include two transistors (e.g., driving transistor DRT and scan transistor SCT) and one capacitor (storage capacitor Cst), which is referred to as "2T1C structure" as shown in FIG. 3, and in some cases, may further include one or more transistors, or further include one or more capacitors.

The storage capacitor Cst may be an external capacitor designed to be located outside of the driving transistor DRT, other than an internal capacitor, such as a parasitic capacitor (e.g., a parasitic Cgs, a parasitic Cgd), that may be present between the first node N1 and the second node N2 of the driving transistor DRT.

Each of the driving transistor DRT and the scan transistor SCT may be an n-type transistor or a p-type transistor.

Circuit elements (in particular, a light emitting element ED) in each subpixel SP may be vulnerable to external moisture or oxygen and an encapsulation layer ENCAP may be disposed in the display panel 110 to prevent the external moisture or oxygen from penetrating the circuit elements (in particular, the light emitting element ED). The encapsulation layer ENCAP may be disposed to cover the light emitting element ED.

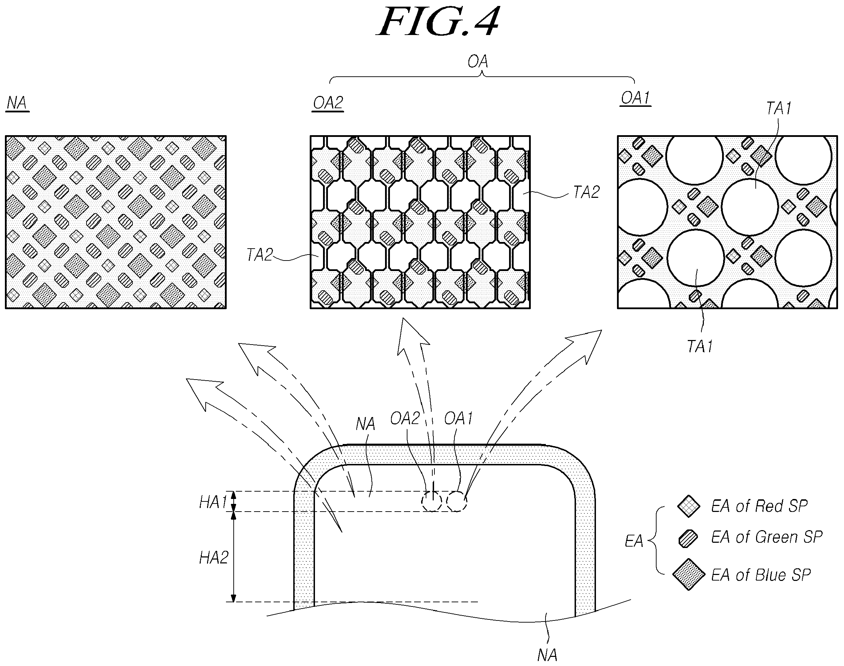

FIG. 4 illustrates arrangements of subpixels SP in the three areas NA, OA1, OA2 included in the display area DA of the display panel 110 according to aspects of the present disclosure.

Referring to FIG. 4, a plurality of subpixels SP may be disposed in each of the normal area NA, the first optical area OA1, and the second optical area OA2 included in the display area DA.

The plurality of subpixels SP may include, for example, a red subpixel (Red SP) for emitting red light, a green subpixel (Green SP) for emitting green light, and a blue subpixel (Blue SP) for emitting blue light.

Accordingly, each of the normal area NA, the first optical area OA1, and the second optical area OA2 may include one or more light emitting areas EA of one or more red subpixels (Red SP), and one or more light emitting areas EA of one or more green subpixels (Green SP), and one or more light emitting areas EA of one or more blue subpixels (Blue SP).

The normal area NA may not include a light transmission structure but may include light emitting areas EA.

However, the first optical area OA1 and the second optical area OA2 should include both the light emitting areas EA and the light transmission structure to receive light.

Accordingly, the first optical area OA1 can include light emitting areas EA and first transmissive areas TA1, and the second optical area OA2 can include the light emitting areas EA and second transmissive area TA2.

The light emitting areas EA and the transmissive areas TA1, TA2 may be distinct according to whether the transmission of light is allowed. That is, the light emitting areas EA may not allow light incident to the light emitting areas EA to be transmitted into the display area DA, and the transmissive areas TA1, TA2 may be areas allowing light incident to the transmissive areas TA1, TA2 to be transmitted into the display area DA.

The light emitting areas EA and the transmissive areas TA1, TA2 may be also distinct according to whether or not a specific metal layer CE is included. For example, the cathode electrode CE may be disposed in the light emitting areas EA, and the cathode electrode CE may not be disposed in the transmissive areas TA1, TA2. Further, a light shield layer may be disposed in the light emitting areas EA, and the light shield layer may not be disposed in the transmissive areas TA1, TA2.

Since the first optical area OA1 includes the first transmissive areas TA1 and the second optical area OA2 includes the second transmissive areas TA2, both of the first optical area OA1 and the second optical area OA2 are areas through which light can pass.

In one aspect, a transmittance (e.g., a degree of transmission) of the first optical area OA1 and a transmittance (e.g., a degree of transmission) of the second optical area OA2 may be substantially equal.

In this case, the first transmissive area TA1 of the first optical area OA1 and the second transmissive area TA2 of the second optical area OA2 may have a substantially equal shape or size. In another example, even when the first transmissive area TA1 of the first optical area OA1 and the second transmissive area TA2 of the second optical area OA2 have different shapes or sizes, a ratio of the first transmissive area TA1 in the first optical area OA1 and a ratio of the second transmissive area TA2 in the second optical area OA2 may be substantially equal.

In another embodiment, a transmittance (a degree of transmission) of the first optical area OA1 and a transmittance (e.g., a degree of light transmission) of the second optical area OA2 may be different.

In this case, in one example, the first transmissive area TA1 of the first optical area OA1 and the second transmissive area TA2 of the second optical area OA2 may have different shapes or sizes. In another example, even when the first transmissive area TA1 of the first optical area OA1 and the second transmissive area TA2 of the second optical area OA2 have a substantially equal shape or size, a ratio of the first transmissive area TA1 in the first optical area OA1 and a ratio of the second transmissive area TA2 in the second optical area OA2 may be different from each other.

For example, in a case where the first optical electronic device 11 overlapping the first optical area OA1 is a camera, and the second optical electronic device 12 overlapping the second optical area OA2 is a sensor for detecting images, the camera may need a greater amount of light than the sensor.

Thus, in this case, the transmittance (e.g., the degree of light transmission) of the first optical area OA1 may be greater than the transmittance (degree of transmission) of the second optical area OA2.

Further, in this case, the first transmissive area TA1 of the first optical area OA1 may have a size greater than the second transmissive area TA2 of the second optical area OA2. In another example, even when the first transmissive area TA1 of the first optical area OA1 and the second transmissive area TA2 of the second optical area OA2 have a substantially equal size, a ratio of the first transmissive area TA1 in the first optical area OA1 may be greater than a ratio of the second transmissive area TA2 in the second optical area OA2.

For convenience of description, the discussion that follows is based on an aspect in which the transmittance (e.g., a degree of light transmission) of the first optical area OA1 is greater than the transmittance (e.g., a degree of light transmission) of the second optical area OA2.

Further, the transmissive areas TA1, TA2 as shown in FIG. 4 may be referred to as transparent areas, and the term transmittance may be referred to as transparency.

Further, in the discussion that follows, it is assumed that the first optical area OA1 and the second optical area OA2 are located in an upper edge of the display area DA of the display panel 110 and are disposed to be horizontally adjacent to each other such as being disposed in a direction in which the upper edge extends, as shown in FIG. 4, unless explicitly stated otherwise.

Referring to FIG. 4, a horizontal display area in which the first optical area OA1 and the second optical area OA2 are disposed is referred to as a first horizontal display area HA1, and another horizontal display area in which the first optical area OA1 and the second optical area OA2 are not disposed is referred to as a second horizontal display area HA2.

Referring to FIG. 4, the first horizontal display area HA1 may include the normal area NA, the first optical area OA1, and the second optical area OA2. The second horizontal display area HA2 may include only the normal area NA.

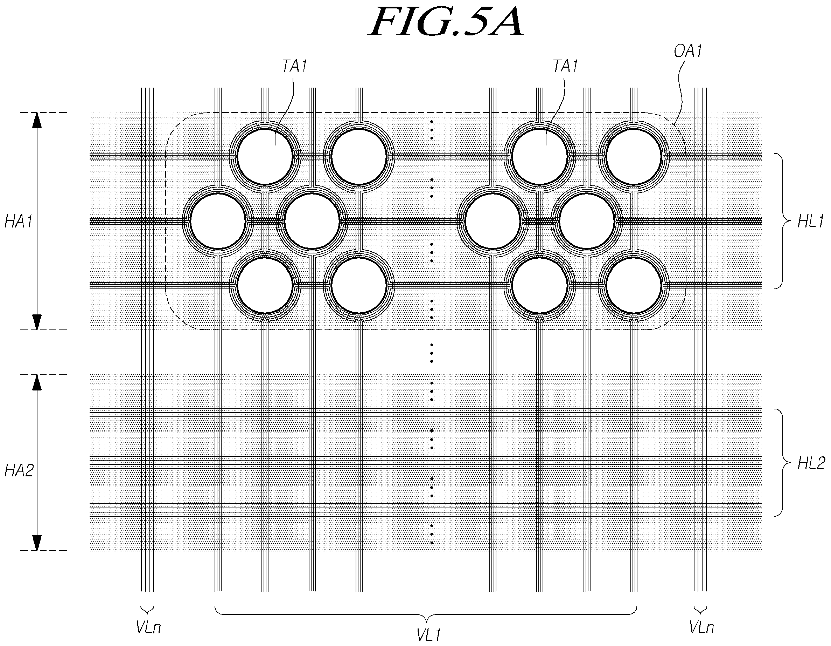

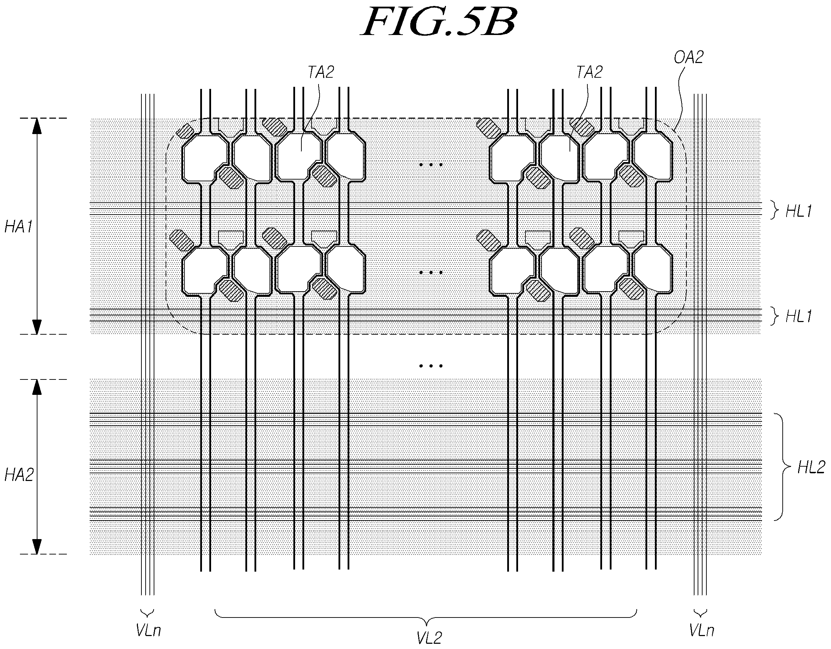

FIG. 5A illustrates arrangements of signal lines in each of the first optical area OA1 and the normal area NA of the display panel 110 according to aspects of the present disclosure, and FIG. 5B illustrates arrangements of signal lines in each of the second optical area OA2 and the normal area NA of the display panel 110 according to aspects of the present disclosure.

Referring to FIGS. 5A and 5B, the display panel 110 of the present disclosure, first horizontal display areas HA1 shown in FIGS. 5A and 5B correspond to parts of a first horizontal display area HA1 of the display panel 110, and second horizontal display areas HA2 therein correspond to parts of a second horizontal display area HA2 of the display panel 110.

The first optical area OA1 of FIG. 5A corresponds to a part of the first optical area OA1 of the display panel 110, and the second optical area OA2 of FIG. 5B corresponds to a part of the second optical area OA2 of the display panel 110.

Referring to FIGS. 5A and 5B, the first horizontal display area HA1 may include the normal area NA, the first optical area OA1, and the second optical area OA2. The second horizontal display area HA2 may include the normal area NA.

Various types of horizontal lines HL1, HL2 and various types of vertical lines VLn, VL1, VL2 may be disposed in the display panel 110.

In some aspects, the term "horizontal" and the term "vertical" are used to refer to two directions intersecting the display panel; however, it should be noted that the horizontal direction and the vertical direction may be changed depending on a viewing direction. The horizontal direction may refer to, for example, a direction in which one gate line GL is disposed to extend and, and the vertical direction may refer to, for example, a direction in which one data line DL is disposed to extend. As such, the term horizontal and the term vertical are used to represent two directions.

Referring to FIGS. 5A and 5B, the horizontal lines disposed in the display panel 110 may include first horizontal lines HL1 disposed in the first horizontal display area HA1 and second horizontal lines HL2 disposed on the second horizontal display area HA2.

The horizontal lines disposed in the display panel 110 may be gate lines GL. That is, the first horizontal lines HL1 and the second horizontal lines HL2 may be the gate lines GL. The gate lines GL may include various types of gate lines according to structures of one or more subpixels SP.

Referring to FIGS. 5A and 5B, the vertical lines disposed in the display panel 110 may include typical vertical lines VLn disposed only in the normal area NA, first vertical lines VL1 running through both of the first optical area OA1 and the normal area NA, second vertical lines VL2 running through both of the second optical area OA2 and the normal area NA.

The vertical lines disposed in the display panel 110 may include data lines DL, driving voltage lines DVL, and the like, and may further include reference voltage lines, initialization voltage lines, and the like. That is, the typical vertical lines VLn, the first vertical lines VL1 and the second vertical lines VL2 may include the data lines DL, the driving voltage lines DVL, and the like, and may further include the reference voltage lines, the initialization voltage lines, and the like.

In some aspects, it should be noted that the term "horizontal" in the second horizontal line HL2 may mean only that a signal is carried from a left side to a right side (or from the right side to the left side), and may not mean that the second horizontal line HL2 runs in a straight line only in the direct horizontal direction. For example, in FIGS. 5A and 5B, although the second horizontal lines HL2 are illustrated in a straight line, however, one or more of the second horizontal lines HL2 may include one or more bent or folded portions differently from the configurations thereof. Likewise, one or more of the first horizontal lines HL1 may also include one or more bent or folded portions.

In some aspects, it should be noted that the term "vertical" in the typical vertical line VLn may mean only that a signal is carried from an upper portion to a lower portion (or from the lower portion to the upper portion), and may not mean that the typical vertical line VLn runs in a straight line only in the direct vertical direction. For example, in FIGS. 5A and 5B, although the typical vertical lines VLn are illustrated in a straight line, however, one or more of the typical vertical lines VLn may include one or more bent or folded portions differently from the configurations thereof. Likewise, one or more of the first vertical line VL1 and one or more of the second vertical line VL2 may also include one or more bent or folded portions.

Referring to FIG. 5A, the first optical area OA1 included in the first horizontal area HA1 may include light emitting areas EA and first transmissive areas TA1. In the first optical area OA1, respective outer areas of the first transmissive areas TA1 may include corresponding light emitting areas EA.

Referring to FIG. 5A, in order to improve the transmittance of the first optical area OA1, the first horizontal lines HL1 may run through the first optical area OA1 by avoiding the first transmissive areas TA1 in the first optical area OA1.

Accordingly, each of the first horizontal lines HL1 running through the first optical area OA1 may include one or more curved or bent portions running around one or more respective outer edges of one or more of the first transmissive areas TA1.

Accordingly, the first horizontal lines HL1 disposed in the first horizontal area HA1 and the second horizontal lines HL2 disposed in the second horizontal area HA2 may have different shapes or lengths. That is, the first horizontal lines HL1 running through the first optical area OA1 and the second horizontal lines HL2 not running through the first optical area OA1 may have different shapes or lengths.

Further, in order to improve the transmittance of the first optical area OA1, the first vertical lines VL1 may run through the first optical area OA1 by avoiding the first transmissive areas TA1 in the first optical area OA1.

Accordingly, each of the first vertical lines VL1 running through the first optical area OA1 may include one or more curved or bent portions running around one or more respective outer edges of one or more of the first transmissive areas TA1.

Thus, the first vertical lines VL1 running through the first optical area OA1 and the typical vertical lines VLn disposed in the normal area NA without running through the first optical area OA1 may have different shapes or lengths.

Referring to FIG. 5A, the first transmissive areas TA1 included in the first optical area OA1 in the first horizontal area HA1 may be arranged in a diagonal direction.

Referring to FIG. 5A, in the first optical area OA1 in the first horizontal area HA1, one or more light emitting areas EA may be disposed between two horizontally adjacent first transmissive areas TA1. In the first optical area OA1 in the first horizontal area HA1, one or more light emitting areas EA may be disposed between two vertically adjacent first transmissive areas TA1.

Referring to FIG. 5A, the first horizontal lines HL1 disposed in the first horizontal area HA1, that is, the first horizontal lines HL1 running through the first optical area OA1 each may include one or more curved or bent portions running around one or more respective outer edges of one or more of the first transmissive areas TA1.

Referring to FIG. 5B, the second optical area OA2 included in the first horizontal area HA1 may include light emitting areas EA and second transmissive areas TA2. In the second optical area OA2, respective outer areas of the second transmissive areas TA2 may include corresponding light emitting areas EA.

In one embodiment, the light emitting areas EA and the second transmissive areas TA2 in the second optical area OA2 may have locations and arrangements substantially equal to the light emitting areas EA and the first transmissive areas TA1 in the first optical area OA1 of FIG. 5A.

In another aspect, as shown in FIG. 5B, the light emitting areas EA and the second transmissive areas TA2 in the second optical area OA2 may have locations and arrangements different from the light emitting areas EA and the first transmissive areas TA1 in the first optical area OA1 of FIG. 5A.

For example, referring to FIG. 5B, the second transmissive area TA2 in the second optical area OA2 may be arranged in the horizontal direction (e.g., from the left to right direction or the right to left direction). A light emitting area EA may not be disposed between two second transmissive areas TA2 adjacent to each other in the horizontal direction. Further, one or more of the light emitting areas EA in the second optical area OA2 may be disposed between second transmissive areas TA2 adjacent to each other in the vertical direction (e.g., from the top to bottom direction or bottom to top direction). That is, one or more light emitting areas EA may be disposed between two rows of second transmissive areas.

When running through the second optical area OA2 in the first horizontal area HA1 and the normal area NA adj acent to the second optical area OA2, in one embodiment, the first horizontal lines HL1 may have substantially the same arrangement as FIG. 5A.

In another embodiment, as shown in FIG. 5B, when running through the second optical area OA2 in the first horizontal area HA1 and the normal area NA adjacent to the second optical area OA2, the first horizontal lines HL1 may have an arrangement different from FIG. 5A.

This is because that the light emitting areas EA and the second transmissive areas TA2 in the second optical area OA2 of FIG. 5B have locations and arrangements different from the light emitting areas EA and the first transmissive areas TA1 in the first optical area OA1 of FIG. 5A.

Referring to FIG. 5B, when the first horizontal lines HL1 run through the second optical area OA2 in the first horizontal area HA1 and the normal area NA adjacent to the second optical area OA2, the first horizontal lines HL1 may run between vertically adjacent second transmissive areas TA2 in a straight line without having a curved or bent portion.

In other words, one first horizontal line HL1 may have one or more curved or bent portions in the first optical area OA1, but may not have a curved or bent portion in the second optical area OA2.

In order to improve the transmittance of the second optical area OA2, the second vertical lines VL2 may run through the second optical area OA2 by avoiding the second transmissive areas TA2 in the second optical area OA2.

Accordingly, each of the second vertical lines VL2 running through the second optical area OA2 may include one or more curved or bent portions running around one or more respective outer edges of one or more of the second transmissive areas TA2. In this illustrative example, portions of the second vertical lines VL2 may be routed and shaped based on the green subpixels. For example, a shape of the transmissive area TA2 may have a concave portion in the based on a position of green subpixel.

Thus, the second vertical lines VL2 running through the second optical area OA2 and the typical vertical lines VLn disposed in the normal area NA without running through the second optical area OA2 may have different shapes or lengths.

As shown in FIG. 5A, at least one of the first horizontal lines HL1 running through the first optical area OA1 may have one or more curved or bent portions running around one or more respective outer edges of one or more of the first transmissive areas TA1.

Accordingly, a length of the first horizontal line HL1 running through the first optical area OA1 and the second optical area OA2 may be slightly longer than a length of the second horizontal line HL2 disposed only in the normal area NA without running through the first optical area OA1 and the second optical area OA2.

Accordingly, a resistance of the first horizontal line HL1 running through the first optical area OA1 and the second optical area OA2, which is referred to as a first resistance, may be slightly greater than a resistance of the second horizontal line HL2 disposed only in the normal area NA without running through the first optical area OA1 and the second optical area OA2, which is referred to as a second resistance.

Referring to FIGS. 5A and 5B, according to a light transmitting structure, since the first optical area OA1 that at least partially overlaps the first optical electronic device 11 includes the first transmissive areas TA1, and the second optical area OA2 that at least partially overlaps with the second optical electronic device 12 includes the second transmissive areas TA2, the first optical area OA1 and the second optical area OA2 may have a smaller number of subpixels per unit area than the normal area NA.

Accordingly, the number of subpixels connected to each, or one or more, of the first horizontal lines HL1 running through the first optical area OA1 and the second optical area OA2 may be different from the number of subpixels connected to each, or one or more, of the second horizontal lines HL2 disposed only in the normal area NA without running through the first optical area OA1 and the second optical area OA2.

The number of subpixels connected to each, or one or more, of the first horizontal lines HL1 running through the first optical area OA1 and the second optical area OA2, which is referred to as a first number, may be smaller than the number of subpixels connected to each, or one or more, of the second horizontal lines HL2 disposed only in the normal area NA without running through the first optical area OA1 and the second optical area OA2, which is referred to as a second number.

A difference between the first number and the second number may vary according to a difference between a resolution of each of the first optical area OA1 and the second optical area OA2 and a resolution of the normal area NA. For example, as a difference between a resolution of each of the first optical area OA1 and the second optical area OA2 and a resolution of the normal area NA increases, a difference between the first number and the second number may increase.

As described above, because the number (e.g., the first number) of subpixels connected to each, or one or more, of the first horizontal lines HL1 running through the first optical area OA1 and the second optical area OA2 is smaller than the number of subpixels (e.g., the second number) connected to each, or one or more, of the second horizontal lines HL2 disposed only in the normal area NA without running through the first optical area OA1 and the second optical area OA2, an area where the first horizontal line HL1 overlaps one or more other electrodes or lines adjacent to the first horizontal line HL1 may be smaller than an area where the second horizontal line HL2 overlaps one or more other electrodes or lines adjacent to the second horizontal line HL2.

Accordingly, a parasitic capacitance formed between the first horizontal line HL1 and one or more other electrodes or lines adjacent to the first horizontal line HL1, which is referred to as a first capacitance, may be much smaller than a parasitic capacitance formed between the second horizontal line HL2 and one or more other electrodes or lines adjacent to the second horizontal line HL2, which is referred to as a second capacitance.

Considering a relationship in magnitude between the first resistance and the second resistance (e.g., the first resistance ≥ the second resistance) and a relationship in magnitude between the first capacitance and the second capacitance (the first capacitance << second capacitance), a resistance-capacitance (RC) value of the first horizontal line HL1 running through the first optical area OA1 and the second optical area OA2, which is referred to as a first RC value, may be much smaller than an RC value of the second horizontal lines HL2 disposed only in the normal area NA without running through the first optical area OA1 and the second optical area OA2, which is referred to as a second RC value, that is, resulting in the first RC value << the second RC value.

Due to such a difference between the first RC value of the first horizontal line HL1 and the second RC value of the second horizontal line HL2, which is referred to as RC load differentiation, a signal transmission characteristic through the first horizontal line HL1 may be different from a signal transmission characteristic through the second horizontal line HL2.

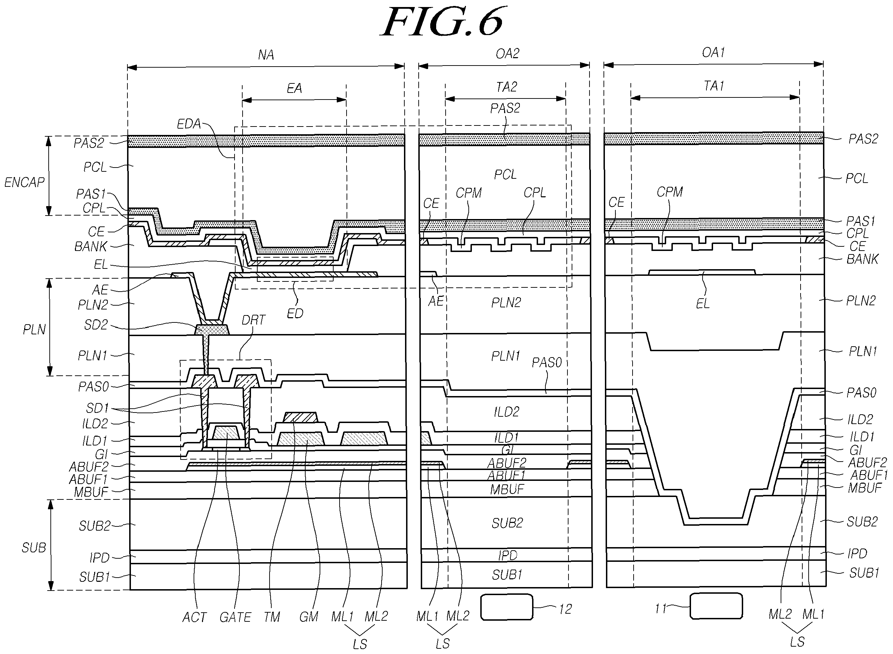

FIG. 6 is cross-sectional view of an optical area OA of the display panel 110 according to aspects of the present disclosure.

Referring to FIG. 6, the optical area OA of the display panel 110 according to aspects of the present disclosure may include a light emitting area EA, a first transmissive area TA1, and a second transmissive area TA2.

The light emitting area EA in the optical area OA may have the same stack structure as the light emitting area EA in the normal area NA.

A substrate SUB may include a first substrate SUB1, an interlayer insulating layer IPD, and a second substrate SUB2. The interlayer insulating layer IPD may be located between the first substrate SUB1 and the second substrate SUB2. As the substrate SUB includes the first substrate SUB 1, the interlayer insulating layer IPD, and the second substrate SUB2, the substrate SUB can prevent the penetration of moisture. The first substrate SUB1 and the second substrate SUB2 may be, for example, polyimide (PI) substrates. The first substrate SUB1 may be referred to as a primary PI substrate, and the second substrate SUB2 may be referred to as a secondary PI substrate.

Various types of patterns ACT, SD1, GATE for composing one or more transistors such as a driving transistor DRT, and the like, various types of insulating layers MBUF, ABUF1, ABUF2, GI, ILD1, ILD2, PASO, and various types of metal patterns TM, GM, ML1, ML2 may be disposed over the substrate SUB in the light emitting area EA.

A multi-buffer layer MBUF may be disposed on the second substrate SUB2, and a first active buffer layer ABUF1 may be disposed on the multi-buffer layer MBUF.

A first metal layer ML1 and a second metal layer ML2 may be disposed on the first active buffer layer ABUF1. The first metal layer ML1 and the second metal layer ML2 may be, for example, a light shield layer LS for shielding light.

A second active buffer layer ABUF2 may be disposed on the first metal layer ML1 and the second metal layer ML2. An active layer ACT of the driving transistor DRT may be disposed on the second active buffer layer ABUF2.

A gate insulating layer GI may be disposed to cover the active layer ACT.

A gate electrode GATE of the driving transistor DRT may be disposed on the gate insulating layer GI. In this situation, together with the gate electrode GATE of the driving transistor DRT, a gate material layer GM may be disposed on the gate insulating layer GI at a location different from a location where the driving transistor DRT is disposed.

The first interlayer insulating layer ILD1 may be disposed to cover the gate electrode GATE and the gate material layer GM. A metal pattern TM may be disposed on the first interlayer insulating layer ILD1. The metal pattern TM may be located at a location different from a location where the driving transistor DRT is formed. A second interlayer insulating layer ILD2 may be disposed to cover the metal pattern TM on the first interlayer insulating layer ILD1.

Two first source-drain electrode patterns SD1 may be disposed on the second interlayer insulating layer ILD2. One of the two first source-drain electrode patterns SD1 may be a source node of the driving transistor DRT, and the other may be a drain node of the driving transistor DRT.

The two first source-drain electrode patterns SD1 may be electrically connected to first and second side portions of the active layer ACT, respectively, through contact holes formed in the second interlayer insulating layer ILD2, the first interlayer insulating layer ILD1, and the gate insulating layer GI.

A portion of the active layer ACT overlapping the gate electrode GATE may be a channel region. One of the two first source-drain electrode patterns SD1 may be connected to the first side portion of the channel region of the active layer ACT, and the other of the two first source-drain electrode patterns SD1 may be connected to the second side portion of the channel region of the active layer ACT.

A passivation layer PAS0 is disposed to cover the two first source-drain electrode patterns SD1. A planarization layer PLN may be disposed on the passivation layer PAS0. The planarization layer PLN may include a first planarization layer PLN1 and a second planarization layer PLN2.

The first planarization layer PLN1 may be disposed on the passivation layer PAS0.

A second source-drain electrode pattern SD2 may be disposed on the first planarization layer PLN1. The second source-drain electrode pattern SD2 may be connected to one of the two first source-drain electrode patterns SD1 through a contact hole formed in the first planarization layer PLN1.

The second planarization layer PLN2 may be disposed to cover the second source-drain electrode pattern SD2. A light emitting element ED may be disposed on the second planarization layer PLN2.

Looking at the stacked structure of the light emitting element ED, an anode electrode AE may be disposed on the second planarization layer PLN2. The anode electrode AE may be electrically connected to the second source-drain electrode pattern SD2 through a contact hole of the second planarization layer PLN2.

A bank BANK may be disposed to cover a portion of the anode electrode AE. A portion of the bank BANK corresponding to a light emitting area EA of the subpixel SP may be opened.

A portion of the anode electrode AE may be exposed through the opening (the opened portion) of the bank BANK. An light emitting layer EL may be positioned on side surfaces of the bank BANK and in the opening (the opened portion) of the bank BANK. All or at least a portion of the light emitting layer EL may be positioned between adjacent banks.

In the opening of the bank BANK, the light emitting layer EL may contact the anode electrode AE. A cathode electrode CE may be disposed on the light emitting layer EL.

The light emitting element ED can be formed by comprising the anode electrode AE, the light emitting layer EL, and the cathode electrode CE, as described above. The light emitting layer EL may include an organic layer.

A capping layer CPL may be disposed over the light emitting element ED to improve light extraction and protect the light emitting element ED. The capping layer CPL may be composed of an organic material having a low molecular structure.

An encapsulation layer ENCAP may be disposed on the capping layer CPL. The encapsulation layer ENCAP may have a single-layer structure or a multi-layer structure For example, the encapsulation layer ENCAP may include a first encapsulation layer PAS1, a second encapsulation layer PCL, and a third encapsulation layer PAS2.

The first encapsulation layer PAS1 and the third encapsulation layer PAS2 may be an inorganic layer, and the second encapsulation layer PCL may be, for example, an organic layer. Among the first encapsulation layer PAS1, the second encapsulation layer PCL, and the third encapsulation layer PAS2, the second encapsulation layer PCL may be the thickest and serve as a planarization layer.

The first encapsulation layer PAS1 may be disposed on the cathode electrode CE and may be disposed closest to the light emitting element ED. The first encapsulation layer PAS1 may include an inorganic insulating material capable of being deposited using low-temperature deposition. For example, the first encapsulation layer PAS1 may include, but not limited to, silicon nitride (SiNx), silicon oxide (SiOx), silicon oxynitride (SiON), aluminum oxide (Al2O3), or the like. Since the first encapsulation layer PAS1 can be deposited in a low temperature atmosphere, during the deposition process, the first encapsulation layer PAS1 can prevent the light emitting layer EL including an organic material vulnerable to a high temperature atmosphere from being damaged.

The second encapsulation layer PCL may have a smaller area than the first encapsulation layer PAS1. In this case, the second encapsulation layer PCL may be disposed to expose both ends or edges of the first encapsulation layer PAS1. The second encapsulation layer PCL can serve as a buffer for relieving stress between corresponding layers while the display device 100 is curved or bent, and also serve to enhance planarization performance. For example, the second encapsulation layer PCL may include an organic insulating material, such as acrylic resin, epoxy resin, polyimide, polyethylene, silicon oxycarbon (SiOC), or the like. The second encapsulation layer PCL may be disposed, for example, using an inkjet scheme.

The third encapsulation layer PAS2 may be disposed over the substrate SUB over which the second encapsulation layer PCL is disposed to cover the respective top surfaces and side surfaces of the second encapsulation layer PCL and the first encapsulation layer PAS1. The third encapsulation layer PAS2 can minimize or prevent external moisture or oxygen from penetrating into the first encapsulation layer PAS1 and the second encapsulation layer PCL. For example, the third encapsulation layer PAS2 may include an inorganic insulating material, such as silicon nitride (SiNx), silicon oxide (SiOx), silicon oxynitride (SiON), aluminum oxide (Al2O3), or the like.

Next, a stack structure of the first transmissive area TA1 will be described.

The cathode electrode CE may be disposed in the light emitting areas EA but may not be disposed in the first transmissive area TA1. That is, the first transmissive area TA1 may correspond to an opening of the cathode electrode CE.

Further, the light shield layer LS including at least one of the first metal layer ML1 and the second metal layer ML2 may be disposed in the light emitting area EA but may not be disposed in the first transmissive area TA1. That is, the first transmissive area TA1 may correspond to an opening of the light shield layer LS.

The substrate SUB1, SUB2, and the various types of insulating layers MBUF, ABUF1, ABUF2, GI, ILD1, ILD2, PASO, PLN (PLN1, PLN2), BANK, ENCAP (PAS1, PCL, PAS2), T-BUF, T-ILD, PAC disposed in the light emitting area EA may be disposed in the first transmissive area TA1, equally, substantially equally, or similarly.

In this case, the bank BANK formed in the first transmissive area TA1 may have an opening. Alternatively, when the bank BANK is made of a transparent material, it may be formed at a constant height like the light emitting area EA.

The display panel 110 of the present disclosure may form an engraved pattern having a concave grooves and recessed regions with a certain size on the surface of the bank BANK to improve the bonding force between the bank BANK and its upper layer.

In addition, the cathode patterning material CPM, which is capable of improving light transmittance, may be formed on the upper portion of the bank BANK. The cathode patterning material CPM may be composed of an organic material and may be deposited to cover at least a portion of the first transmissive area TA1 using a fine metal mask (FMM).

The cathode patterning material CPM may be used to improve the light transmittance of the transmissive area TA and to effectively pattern the cathode electrode CE formed in the light emitting area EA.

That is, the cathode electrode CE may be effectively formed in the light emitting area EA except for the cathode patterning material CPM by depositing the cathode electrode CE in the light emitting area EA using an open metal mask (OMM) after forming the cathode patterning material CPM in the transmissive area TA using a fine metal mask (FMM). Accordingly, the cathode patterning material CPM and the cathode electrode CE may be positioned on the same plane.

At this time, the cathode patterning material CPM and the capping layer CPL are made of different types of organic materials. Therefore, when they are exposed to a high temperature or high humidity environment for a long time, the surface between the cathode patterning material CPM and the capping layer CPL may become separated or delaminated.

However, if the surface of the bank BANK is formed in an engraved pattern with a certain shape as in the display device 100 of the present disclosure, the contact area may increase and the bonding force may increase since the cathode patterning material CPM deposited on the surface of the bank BANK flows into the inside of the pattern of the bank BANK during the deposition process.

The capping layer CPL may be disposed on the cathode patterning material CPM to protect the first transmissive area TA1. The capping layer CPL may be composed of an organic material having a low molecular structure.

At this time, since the thickness of the cathode patterning material CPM is thin, the interface area between the capping layer CPL and the cathode patterning material CPM may increase by the pattern formed on the surface of the bank BANK, so that the bonding force is also may increase.

As a result, a phenomenon in which the cathode patterning material CPM and the capping layer CPL are delaminated is reduced, and defects of the display device 100 may be reduced.

On the other hand, material layers having electrical properties (e.g., a metal material layer, a semiconductor layer, etc.), except for the insulating materials, disposed in the light emitting areas EA may not be disposed in the first transmissive area TA1.

For example, metal material layers ML1, ML2, GATE, GM, TM, SD1, SD2 related to at least one transistor and the semiconductor layer ACT may not be disposed in the first transmissive area TA1.

Further, the anode electrode AE and the cathode electrode CE included in the light emitting element ED may not be disposed in the first transmissive area TA1. In this case, it should be noted that the light emitting layer EL of the light emitting element ED may or may not be disposed in the first transmissive area TA1.

Accordingly, the light transmittance of the first transmissive area TA1 may be provided because the material layers (e.g., the metal material layer, the semiconductor layer, etc.) having electrical properties are not disposed in the first transmissive area TA1. As a consequence, the first optical electronic device 11 can receive light transmitting through the first transmissive area TA1 and perform a corresponding function (e.g., image sensing).

Since all or a portion of the first transmissive area TA1 overlaps the first optical electronic device 11, the first transmissive area TA1 should have a transmittance for enabling the incident light to be received by the first optical electronic device 11 to normally operate.

To do this, in the display panel 110 of the display device 100 according to aspects of the present disclosure, various transmittance improvement structures (TIS) can be provided to the first transmissive area TA1 in the first optical area OA1.

A plurality of insulating layers included in the display panel 110 may include the buffer layers MBUF, ABUF1, ABUF2 between at least one substrate SUB1, SUB2 and at least one transistor DRT, SCT, the planarization layers PLN1, PLN2 between the transistor DRT and the light emitting element ED, the encapsulation layer ENCAP on the light emitting element ED, and the like.

The first transmissive area TA1 may have a structure in which the first planarization layer PLN1 and the passivation layer PAS0 have depressed portions that extend downward from respective surfaces thereof that forms a TIS to improve transmittance.

Among the plurality of insulating layers, the first planarization layer PLN1 may include at least one depression (e.g., a recess, a trench, a concave region, a protrusion, etc.). The first planarization layer PLN1 may be, for example, an organic insulating layer.

In a case where the first planarization layer PLN1 includes the depressed portion that extends downward from the surfaces thereof, the second planarization layer PLN2 can substantially serve to planarize. In an example, the second planarization layer PLN2 may also have a depressed portion that extends downward from the surface thereof. In this case, the second encapsulation layer PCL can substantially serve to planarize.

The depressed portions of the first planarization layer PLN1 and the passivation layer PAS0 may pass through insulating layers, such as the first interlayer insulating layer ILD, the second interlayer insulating layer ILD2, the gate insulating layer GI, and the like, for forming the transistor DRT, and buffer layers, such as the first active buffer layer ABUF1, the second active buffer layer ABUF2, the multi-buffer layer MBUF, and the like, located under the insulating layers, and may extend up to an upper portion of the second substrate SUB2.

The substrate SUB may include at least one concave portion or depressed portion of that forms a TIS to improve transmittance. For example, in the first transmissive area TA1, an upper portion of the second substrate SUB2 may be indented or depressed downward, or the second substrate SUB2 may be perforated.

The first encapsulation layer PAS1 and the second encapsulation layer PCL included in the encapsulation layer ENCAP may also have a TIS in which the first encapsulation layer PAS 1 and the second encapsulation layer PCL have depressed portions that extend downward from the respective surfaces thereof. The second encapsulation layer PCL may be, for example, an organic insulating layer.

Next, a stack structure of the second transmissive area TA2 will be described.

The cathode electrode CE may be disposed in the light emitting areas EA but may not be disposed in the second transmissive area TA2. That is, the second transmissive area TA2 may correspond to an opening of the cathode electrode CE.

Further, the light shield layer LS including at least one of the first metal layer ML1 and the second metal layer ML2 may be disposed in the light emitting areas EA but may not be disposed in the second transmissive area TA2. That is, the second transmissive area TA2 may correspond to an opening of the light shield layer LS.

When the transmittance of the second transmissive area TA2 and the transmittance of the first transmissive area TA1 are the same, the stacked structure of the second transmissive area TA2 may be the same as the stacked structure of the first transmissive area TA1.

When the transmittance of the second transmissive area TA2 and the transmittance of the first transmissive area TA1 are different, the stacked structure of the second transmissive area TA2 may be at least partially different from the stacked structure of the first transmissive area TA1.

For example, when the transmittance of the second transmissive area TA2 is lower than the transmittance of the first transmissive area TA1, the second transmissive area TA2 may not include a TIS. As a result, the first planarization layer PLN1 and the passivation layer PAS0 may not be indented or depressed. Further, a width of the second transmissive area TA2 may be smaller than a width of the first transmissive area TA1.

The substrate SUB and the various types of insulating layers MBUF, ABUF1, ABUF2, GI, ILD1, ILD2, PASO, PLN (PLN1, PLN2), BANK, ENCAP (PAS1, PCL, PAS2), T-BUF, T-ILD, PAC disposed in the light emitting areas EA may be disposed in the second transmissive area TA2, equally, substantially equally, or similarly.

In this case, the bank BANK formed in the second transmissive area TA2 may be opened to have an opening. Alternatively, when the bank BANK is made of a transparent material, it may be formed at a constant height like the light emitting area EA.

The display panel 110 of the present disclosure may form an engraved pattern having at least one of concave grooves and recessed regions with a certain size on the surface of the bank BANK to improve the bonding force between the bank BANK and its upper layer.

In addition, the cathode patterning material CPM, which is capable of improving light transmittance, may be formed on the upper portion of the bank BANK. The cathode patterning material CPM may be deposited in a portion corresponding to the second transmissive area TA2.

As such, when a pattern with a certain size is formed on the surface of the bank BANK, the contact area and the bonding force may increase because the cathode patterning material CPM flows into the pattern of the bank BANK during the deposition process.

The capping layer CPL may be disposed on the cathode patterning material CPM to protect the second transmissive area TA2. The capping layer CPL may be composed of an organic material having a low molecular structure.

At this time, because the thickness of the cathode patterning material CPM is thin, the bonding force between the capping layer CPL and the cathode patterning material CPM may increase by the pattern formed on the surface of the bank BANK

As a result, a phenomenon in which the cathode patterning material CPM and the capping layer CPL are delaminated is reduced, and defects of the display device 100 may be reduced.

On the other hand, material layers having electrical properties (e.g., a metal material layer, a semiconductor layer, etc.), except for the insulating materials, disposed in the light emitting areas EA may not be disposed in the second transmissive area TA2.

For example, metal material layers ML1, ML2, GATE, GM, TM, SD1, SD2 related to at least one transistor and the semiconductor layer ACT may not be disposed in the second transmissive area TA2.

Further, the anode electrode AE and the cathode electrode CE included in the light emitting element ED may not be disposed in the second transmissive area TA2. In this case, it should be noted that the light emitting layer EL of the light emitting element ED may or may not be disposed in the second transmissive area TA2.

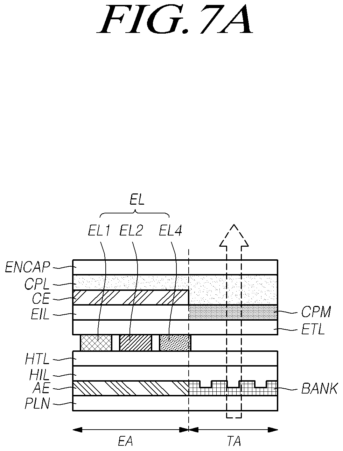

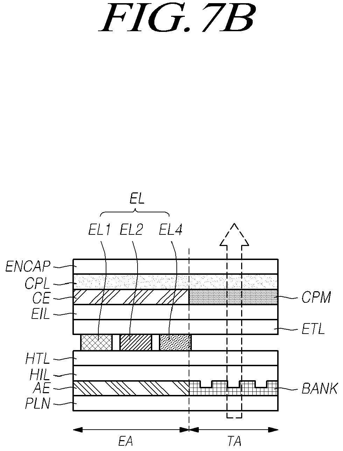

FIGS. 7A and 7B illustrate enlarged views of an area corresponding to the light emitting element ED in the optical area OA of the display panel 110 according to aspects of the present disclosure.

Referring to FIG. 7A, the optical area OA in the display panel 110 according to aspects of the present disclosure may include a light emitting area EA and a transmissive area TA.

The light emitting area EA may include an anode electrode AE formed on the planarization layer PLN, a plurality of light emitting layers EL formed on the anode electrode AE, and a cathode electrode CE formed on the light emitting layer EL while overlapping the plurality of light emitting layers EL.

The anode electrode AE, the light emitting layer EL, and the cathode electrode CE form a light emitting element ED, and the light emitting element ED may be an organic light emitting element or an inorganic light emitting element depending on whether the light emitting layer EL is an organic light emitting layer or an inorganic light emitting layer.

The anode electrode AE formed in the light emitting area EA is connected to the driving transistor to receive an electrical signal.

The light emitting layer EL may include a blue emitting layer EL1, a green emitting layer EL2, and a red emitting layer EL3, and may further include a white emitting layer. Each of the light emitting layers EL may be parallel to each other in the same row, but may be disposed in a diagonal direction or may be disposed in a different arrangement from each other. Although each of the light emitting layers EL are illustrated as having the same size, the light emitting layers EL are not limited thereto. And the light emitting layers EL may be formed in different sizes depending on characteristics of the display device 100.

Although the shape of the light emitting layer EL is illustrated as a quadrangle, it is not limited thereto, and may have a non-rectangular polygonal or oval shape, or at least a portion of a rounded corner. In some cases, the corners of the light emitting layer EL may be arranged adjacent to each other with a predetermined interval.

Meanwhile, a bank BANK may be provided in the transmissive area TA adjacent to the light emitting area EA to define an area. Although not illustrated, the bank BANK may partially overlap the edge of the anode electrode AE.

In addition, a hole injection layer HIL and a hole transfer layer HTL to transfer holes moving from the anode electrode AE to the light emitting layer EL may be disposed between the light emitting layer EL and the anode electrode AE in which substantial light emission is achieved by recombination of holes and electrons.

In addition, an electron injection layer EIL and an electron transfer layer ETL to transfer electrons moving from the cathode electrode CE to the light emitting layer EL may be disposed between the light emitting layer EL and the cathode electrode CE.

The electron injection layer EIL may not contain an organic material and may be made of an inorganic compound such as an alkali compound or a lanthanum metal and may be formed together in a process forming the cathode electrode CE.

The hole injection layer HIL and the electron injection layer EIL may be omitted, and in some cases, the hole transfer layer HTL and the electron transfer layer ETL may be formed as a plurality of layers by providing different functionality, respectively.

The bank BANK is formed in the transmissive area TA in which the light emitting layer EL is not formed in the optical area OA. The light emitting area EA may be defined as an open area of the bank BANK. The bank BANK may be disposed to cover a portion of the anode electrode AE and may be formed of a transparent material for light transmission of the transmissive area TA.

In order to improve the bonding force between the bank BANK and the layer formed thereover, an engraved pattern having at least one of concave grooves and recessed regions of a certain size may be formed on the surface of the bank BANK

When the hole injection layer HIL, the hole transfer layer HTL, and the electron injection layer EIL are formed to cover the light emitting area EA, the hole injection layer HIL, the hole transfer layer HTL, and the electron injection layer EIL may be sequentially stacked on top of the bank BANK having a pattern formed on its surface.

In this case, since the hole injection layer HIL, the hole transfer layer HTL, and the electron injection layer EIL are thin, they may be formed along the pattern formed on top of the bank BANK

In addition, a cathode patterning material CPM capable of improving light transmittance may be formed over the bank BANK. The cathode patterning material CPM may be formed of an organic material and may be deposited to cover at least a portion of the first transmissive area TA1 using a fine metal mask (FMM).

The cathode patterning material CPM may be used to improve the light transmittance of the transmission area TA, and effectively pattern the electron injection layer EIL and the cathode electrode CE formed in the light emitting area EA.

For example, the electron injection layer EIL and the cathode electrode CE may be effectively formed using an open metal mask (OMM) after forming a cathode patterning material CPM in the transmissive area TA using the fine metal mask (FMM).

In this case, the cathode patterning material CPM may be disposed on the same layer as the electron injection layer EIL. A thickness of the cathode patterning material CPM may correspond to a thickness of the electron injection layer EIL or may correspond to the combined thickness of the electron injection layer EIL and the cathode electrode CE.

Alternatively, as shown in FIG. 7B, the electron injection layer EIL may be formed on the light emitting area EA and the transmissive area TA, and a cathode patterning material CPM may be formed in the transmissive area TA using the fine metal mask (FMM).

Then, the cathode electrode CE may be effectively formed in the light emitting area EA using an open metal mask (OMM).

In this case, the cathode patterning material CPM may be disposed on the same layer as the cathode electrode CE, and the thickness of the cathode patterning material CPM may correspond to the thickness of the cathode electrode CE.

At this time, since the surface of the bank BANK is formed in an engraved pattern of a certain shape, the cathode patterning material CPM deposited along the surface of the bank BANK flows into the inside pattern of the bank BANK in the deposition process. Therefore, the contact area may be increased and the bonding force may be increased.

The capping layer CPL may be disposed over the cathode patterning material CPM to protect the first transmissive area TA1. The capping layer CPL may be formed of an organic material having a low molecular structure.

At this time, because the thickness of the cathode patterning material CPM is thin, the bonding force between the capping layer CPL and the cathode patterning material CPM is also increased by the pattern formed on the surface of the bank BANK

As a result, the delamination phenomenon of the cathode patterning material CPM and the capping layer CPL is reduced, and defects of the display device 100 may be reduced.

An encapsulation layer ENCAP is formed on the capping layer CPL to prevent moisture permeation from the outside and to protect the lower light emitting element ED and the thin film transistor.

In the display device 100 of the present disclosure, the pattern formed on the upper surface of the bank BANK in the transmissive area TA of the optical area OA may have various shapes, and position of the concave grooves and recessed regions may be determined in various ways.

In particular, the pattern of the bank BANK may be determined in various ways according to the area and location of the cathode patterning material CPM formed thereover.

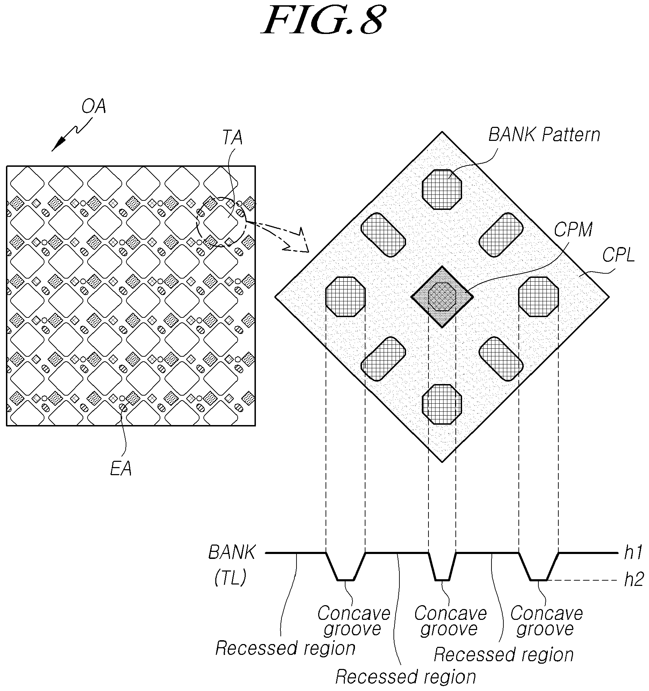

FIGS. 8 to 10 illustrate plan views of structures of a bank pattern and a cathode patterning material formed in a transmissive area of an optical area in a display device according to aspects of the present disclosure.

First, referring to FIG. 8, the optical area OA overlapping the optical electronic device in the display device 100 according to aspects of the present disclosure may be divided into a light emitting area EA in which color subpixels SP are disposed and a transmissive area TA in which the bank BANK is formed. The bank BANK is one of transmissive layer TL for conveying light.

A bank pattern BANK Pattern having at least one of concave grooves and recessed regions of a certain size may be formed on the surface of the bank BANK in the transmissive area TA. In this case, as the depth of the bank pattern BANK Pattern increases, an area in contact with the cathode patterning material CPM increases, but it is preferable that the lower second planarization layer PLN2 is not exposed. Therefore, the height (h2) of the concave grooves are less than height (h1) of the recessed regions.

The bank pattern BANK Pattern may be arranged in an arbitrary shape at positions spaced apart from each other within the entire area where the bank BANK is located. The bank pattern BANK Pattern may be formed in a symmetrical structure or may be formed in a discontinuous structure.

At this time, the depth of the bank pattern BANK Pattern may be all the same, or the depth of some bank patterns BANK Pattern may be different from the depth of other bank patterns BANK Pattern.

FIG. 8 illustrates a case in which a bank pattern BANK Pattern is formed in an octagonal or oval structure as an example, but a bank pattern BANK Pattern may be formed in the shape of various figures such as a circle or a square.

However, to increase the bonding force with the upper cathode patterning material CPM or the capping layer CPL, it may be effective to form the bank pattern BANK Pattern in a polygonal structure of pentagon or more.

Since fluidity of the boundary portion increases when the bank pattern BANK Pattern is formed in a circular shape, the bonding force of the cathode patterning material CPM or the capping layer CPL may be relieved. In addition, according to experimental measurement, when the bank pattern BANK Pattern is formed in a polygonal structure having at least 5 sides (e.g., a pentagon) rather than a bank pattern BANK Pattern having 4 or few sides (e.g., a square), the separation of delamination between the cathode patterning material CPM and the capping layer CPL is reduced. That is, in the case of forming a bank pattern BANK Pattern with a polygonal structure of at least a pentagon, the delamination phenomenon between the cathode patterning material CPM and the capping layer CPL is reduced since the fluidity of the boundary portion is reduced and the contact area with the cathode patterning material CPM or the capping layer CPL is increased.

The cathode patterning material CPM capable of improving light transmittance may be formed over the bank BANK with the bank pattern BANK Pattern, and the cathode patterning material CPM may be deposited to cover at least a portion of the transmissive area TA.

For example, the cathode patterning material CPM may be formed in a rectangular shape in a central portion of the transmissive area TA.

Accordingly, some of the bank patterns BANK Pattern formed on the upper surface of the bank BANK may be in contact with the cathode patterning material CPM, and the remaining portions may not be in contact with the cathode patterning material CPM.

The bank pattern BANK Pattern that is not in contact with the cathode patterning material CPM may be in contact with the capping layer CPL.

At this time, it is preferable that the bank pattern BANK Pattern, which in contact with the cathode patterning material CPM, is 20% or more of the area occupied by the cathode patterning material CPM to increase the bonding force with the cathode patterning material CPM.

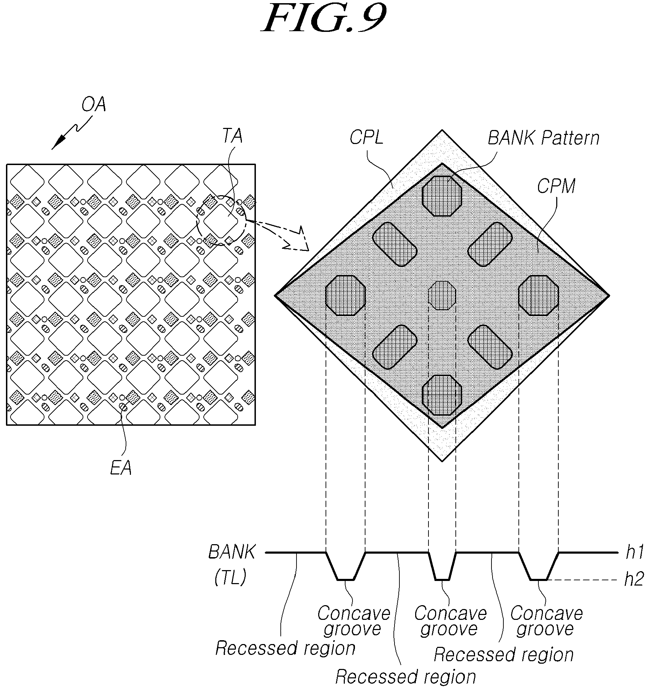

On the other hand, when the area occupied by the bank pattern BANK Pattern is equal (100%) to the area occupied by the cathode patterning material CPM, the bank pattern BANK Pattern may weaken the bonding force between the bank pattern BANK and the cathode patterning material CPM. Accordingly, it is preferable that the area occupied by the bank pattern BANK is 90% or less of the area occupied by the cathode patterning material CPM. Referring to FIG. 9, the display device 100 according to aspects of the present disclosure may include a cathode patterning material CPM capable of improving light transmittance over the bank BANK in which a plurality of bank patterns BANK Pattern are formed.

In this case, the cathode patterning material CPM may be deposited to cover most of the transmissive area TA. For example, when the transmissive area TA has a quadrangular structure, the cathode patterning material CPM may be formed in a quadrangular shape that covers most of the transmissive area TA.

Accordingly, all of the plurality of bank patterns BANK Pattern formed on the upper surface of the bank BANK may be in contact with the cathode patterning material CPM.

Even in this case, it is preferable that the bank pattern BANK Pattern, which is in contact with the cathode patterning material CPM, has an area of 20% or more of the area occupied by the cathode patterning material CPM to increase the bonding force with the cathode patterning material CPM.

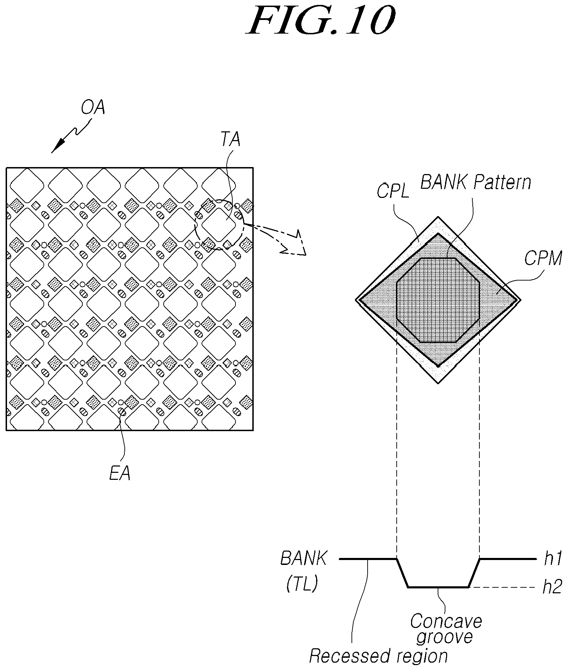

Referring to FIG. 10, the display device 100 according to aspects of the present disclosure may provide a cathode patterning material CPM capable of improving light transmittance over the bank BANK on which one bank pattern BANK Pattern is formed.

In this case, the cathode patterning material CPM may be deposited to cover most of the transmissive area TA. For example, when the transmissive area TA has a quadrangular structure, the cathode patterning material CPM may be formed in a quadrangular shape that covers most of the transmissive area TA.

Accordingly, one bank pattern BANK Pattern formed on the upper surface of the bank BANK may be in contact with the cathode patterning material CPM.

Even in this case, it is preferable that the bank pattern BANK Pattern in contact with the cathode patterning material CPM and has an area of 20% or more of the area occupied by the cathode patterning material CPM to increase the bonding force with the cathode patterning material CPM.

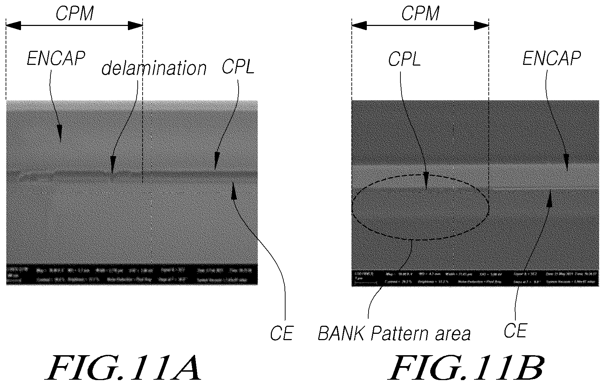

FIGs. 11A and 11B illustrate a cross-sectional photograph comparing a case in which a bank pattern is not formed and a case in which a bank pattern is formed in a transmissive area of an optical area in a display device according to aspects of the present disclosure.

Referring to FIG. 11A, the cathode patterning material CPM and the capping layer CPL formed over the bank BANK in the transmissive area TA of the optical area OA may be made of different series of organic materials. Therefore, as illustrated in FIG. 11A, when exposed to a high temperature or high humidity environment for a long time, the surface between the cathode patterning material CPM and the capping layer CPL may be separated or delaminated

Referring to FIG. 11B, when the surface of the bank BANK is formed in an engraved pattern of a certain shape as in the display device 100 of the present disclosure, the cathode patterning material CPM deposited on the surface of the bank BANK may have a wide contact area and large bonding force since it flows into the inside of the pattern of the bank BANK during the deposition process.

As a result, a phenomenon in which the cathode patterning material CPM and the capping layer CPL are delaminated may be reduced, and defects of the display device 100 may be reduced as illustrated FIG. 11B.

A brief description of the aspects of the present disclosure described above is as follows.

The display device 100 according to aspects of the present disclosure may comprise a display panel 110 in which an optical area OA divided into a transmissive area TA and a light emitting area EA, and a normal area NA including a plurality of light emitting areas EA outside the optical area OA are formed in a display area DA; a gate driving circuit 120 configured to supply a gate signal to the display panel 110; a data driving circuit 130 configured to convert image data into data voltage and supply it to the display panel 110; and a display controller 140 configured to control the gate driving circuit 120 and the data driving circuit 130; wherein the transmissive area TA includes a bank BANK dividing the light emitting area EA and including a bank pattern BANK Pattern formed on an upper surface; a cathode patterning material CPM formed to cover at least a portion of the bank BANK; and a capping layer CPL formed on the cathode patterning material CPM.

The bank BANK may be made of transparent material.

The bank pattern BANK Pattern may be formed as grooves of an engraved structure.

The bank pattern BANK Pattern may be formed in a polygonal structure that is more than a pentagon.

The bank pattern BANK Pattern may be formed of a plurality of patterns spaced apart from each other.

The plurality of patterns may be arranged in a symmetrical structure.

At least some of the plurality of patterns may be disposed to overlap the cathode patterning material CPM.

An area of the pattern disposed to overlap the cathode patterning material CPM may be occupying 20% or more and 90% or less of an entire area in which the cathode patterning material CPM is formed.

The cathode patterning material CPM may be formed to cover all of the plurality of patterns.

The cathode patterning material CPM may be an organic material deposited using a fine metal mask.

The light emitting area EA may include an anode electrode AE, a light emitting layer EL and a cathode electrode CE; wherein the cathode patterning material CPM may be formed on the same layer as the cathode electrode CE.

The light emitting area EA may include an anode electrode AE, a hole injection layer HIL, a hole transfer layer HTL, a light emitting layer EL, an electron transfer layer ETL, an electron injection layer EIL and a cathode electrode CE, and the cathode patterning material CPM may be formed on the same layer as the electron injection layer EIL.

In addition, the display panel 110 according to aspects of the present disclosure may comprise an optical area OA divided into a transmissive area TA and a light emitting area EA; and a normal area NA including a plurality of light emitting areas EA outside the optical area OA in a display area DA; wherein the transmissive area TA may include a bank BANK dividing the light emitting area EA and including a bank pattern BANK Pattern formed on an upper surface; a cathode patterning material CPM formed to cover at least a portion of the bank BANK; and a capping layer CPL formed on the cathode patterning material CPM.

Illustrative aspects of the disclosure include:
Aspect 1. A display device, comprising: a display panel including a light emitting area and a transmissive area for conveying light to a sensor disposed beneath the display panel; wherein the transmissive area comprises: a transmissive layer for conveying light and having a non-planar top surface; and a cathode patterning material formed to cover the non-planar top surface of the transmissive layer.
Aspect 2. The display device of Aspect 1, wherein the transmissive layer comprises at least one recessed region for increasing a surface area of the transmissive layer.
Aspect 3. The display device of any of Aspects 1 to 2, wherein the transmissive layer comprises at least one first recessed region having a first shape and at least one second recessed region having a second shape different from the first shape.
Aspect 4. The display device of any of Aspects 1 to 3, wherein the non-planar top surface comprises a portion of the transmissive layer having a first height and a portion of the transmissive layer having a second height that is less than the first height.
Aspect 5. The display device of any of Aspects 1 to 4, further comprising: a plurality of data lines oriented in a first direction; a plurality of gate lines oriented in a second direction that is different than the first direction, wherein a gate line or a data line within the transmissive area comprises a non-linear region to bypass at least one transmissive area.
Aspect 6. The display device of any of Aspects 1 to 5, wherein a signal transmission characteristic associated with the gate line or the data line that intersects the transmissive area is different from a signal transmission characteristic associated with a gate line or a data line that does not intersect the transmissive area.
Aspect 7. The display device of any of Aspects 1 to 6, wherein the transmissive area further comprises a capping layer formed on the cathode patterning material.
Aspect 8. The display device of any of Aspects 1 to 7, wherein the cathode patterning material covers a portion of the transmissive area, and wherein the capping layer covers an entire transmissive area.
Aspect 9. The display device of any of Aspects 1 to 8, wherein the cathode patterning material is disposed on a top surface of a single recessed region of the at least one recessed region.
Aspect 10. The display device of any of Aspects 1 to 9, wherein the cathode patterning material includes at least one recessed region that corresponds to the at least one recessed region of the transmissive layer, and wherein the capping layer is planar and fills in the at least one recessed region of the cathode patterning material.
Aspect 11. The display device of any of Aspects 1 to 10, wherein the transmissive area comprises a first transmissive area and a second transmissive area, and wherein the first transmissive area is configured to pass more light into the display panel than the second transmissive area.
Aspect 12. A display device, comprising: a display panel including a light emitting area and a transmissive area for conveying light to a sensor disposed beneath the display panel; wherein the transmissive area comprises: a transmissive layer for conveying light and having a first recessed region, wherein the first recessed region is disposed at a center of the transmissive area.
Aspect 13. The display device of Aspect 12, further comprising a cathode patterning material formed on the transmissive layer to bond the cathode patterning material to the transmissive layer.
Aspect 14. The display device of any of Aspects 12 to 13, wherein the transmissive layer further comprises second recessed regions disposed at corners of the transmissive area.
Aspect 15. The display device of any of Aspects 12 to 14, wherein the transmissive layer further comprises third recessed regions disposed at lateral edges of the transmissive area.
Aspect 16. The display device of any of Aspects 12 to 15, wherein a shape of the third recessed regions is different from a shape of the second recessed regions.
Aspect 17. The display device of any of Aspects 12 to 16, wherein the cathode patterning material is formed to cover the first recessed region and expose the second recessed regions.
Aspect 18. The display device of any of Aspects 12 to 17, wherein the cathode patterning material is formed to cover the first recessed region and the second recessed regions.
Aspect 19. The display device of any of Aspects 12 to 18, wherein a size of the cathode patterning material is less than a size of the transmissive area.
Aspect 20. The display device of any of Aspects 12 to 19, wherein the transmissive area further comprises a capping layer formed over the cathode patterning material.

The above description has been presented to enable any person skilled in the art to make and use the technical idea of the present disclosure, and has been provided in the context of a particular application and its requirements. Various modifications, additions and substitutions to the described aspects will be readily apparent to those skilled in the art, and the general principles defined herein may be applied to other aspects and applications without departing from the scope of the present disclosure. The above description and the accompanying drawings provide an example of the technical idea of the present disclosure for illustrative purposes only. That is, the disclosed are intended aspects to illustrate the scope of the technical idea of the present disclosure. Thus, the scope of the present disclosure is not limited to the aspects shown, but is to be accorded the widest scope consistent with the claims. The scope of protection of the present disclosure should be construed based on the following claims.

## Claims

1. A display device (100), comprising:
a display panel (110) including a light emitting area (EA) and a transmissive area (TA1, TA2) for conveying light to a sensor disposed beneath the display panel (110);
wherein the transmissive area (TA1, TA2) comprises:
a transmissive layer (TL) for conveying light and having a non-planar top surface; and
a cathode patterning material (CPM) formed to cover the non-planar top surface of the transmissive layer (TL).

2. The display device (100) of claim 1, wherein the transmissive layer comprises at least one recessed region for increasing a surface area of the transmissive layer.

3. The display device (100) of claim 2, wherein the transmissive layer comprises at least one first recessed region having a first shape and at least one second recessed region having a second shape different from the first shape.

4. The display device (100) of claim 3, wherein the non-planar top surface comprises a portion of the transmissive layer having a first height (h1) and a portion of the transmissive layer having a second height (h2) that is less than the first height (h1).

5. The display device (100) of any of claims 2 to 4, wherein the transmissive area (TA1, TA2) further comprises a capping layer (CPL) formed on the cathode patterning material (CPM).

6. The display device (100) of claim 5, wherein the cathode patterning material (CPM) covers a portion of the transmissive area (TA1, TA2), and wherein the capping layer (CPL) covers the entire transmissive area (TA1, TA2).

7. The display device (100) of claim 6, wherein the cathode patterning material (CPM) is disposed on a top surface of a single recessed region of the at least one recessed region.

8. The display device (100) of claim 7, wherein the cathode patterning material (CPM) includes at least one recessed region that corresponds to the at least one recessed region of the transmissive layer, and wherein the capping layer (CPL) is planar and fills in the at least one recessed region of the cathode patterning material (CPM).

9. The display device (100) of claim 4, further comprising:
a plurality of data lines (DL) oriented in a first direction;
a plurality of gate lines (GL) oriented in a second direction that is different than the first direction, wherein a gate line (GL) or a data line (DL) within the transmissive area (TA1, TA2) comprises a non-linear region to bypass at least one transmissive area.

10. The display device (100) of claim 9, wherein a signal transmission characteristic associated with the gate line (GL) or the data line (DL) that intersects the transmissive area (TA1, TA2) is different from a signal transmission characteristic associated with a gate line (GL) or a data line (DL) that does not intersect the transmissive area (TA1, TA2).

11. The display device (100) of any of claims 1 to 10, wherein the transmissive area (TA1, TA2) comprises a first transmissive area (TA1) and a second transmissive area (TA2), and wherein the first transmissive area (TA1) is configured to pass more light into the display panel (110) than the second transmissive area (TA2).

12. The display device (100) of claim 1, wherein:
the transmissive layer has a first recessed region, wherein the first recessed region is disposed at a center of the transmissive area (TA1, TA2).

13. The display device (100) of claim 12, wherein the transmissive layer further comprises second recessed regions disposed at corners of the transmissive area (TA1, TA2),
wherein, preferably, the transmissive layer further comprises third recessed regions disposed at lateral edges of the transmissive area (TA1, TA2),
wherein, further preferably, a shape of the third recessed regions is different from a shape of the second recessed regions.

14. The display device (100) of claim 13, wherein the cathode patterning material (CPM) is formed to cover the first recessed region and expose the second recessed regions, or wherein the cathode patterning material (CPM) is formed to cover the first recessed region and the second recessed regions.

15. The display device (100) of claim 14, wherein a size of the cathode patterning material (CPM) is less than a size of the transmissive area (TA1, TA2), wherein, preferably, the transmissive area (TA1, TA2) further comprises a capping layer (CPL) formed over the cathode patterning material (CPM).
